(19) Europäisches Patentamt
European Patent Office
Office européen des brevets

(11) **EP 2 670 101 B1**

(12) **EUROPEAN PATENT SPECIFICATION**

(45) Date of publication and mention
of the grant of the patent:
**04.07.2018 Bulletin 2018/27**

(51) Int Cl.:
*H04L 25/49* (2006.01)     *H03K 3/017* (2006.01)
*H03K 7/08* (2006.01)

(21) Application number: **12305599.8**

(22) Date of filing: **31.05.2012**

(54) **A method for pulse width modulation of a signal**

Verfahren zur Pulsweitenmodulation eines Signals

Procédé de modulation de largeur d'impulsion d'un signal

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.12.2013 Bulletin 2013/49**

(73) Proprietors:
- **Alcatel Lucent
  91620 Nozay (FR)**
- **Friedrich-Alexander-Universität
  Erlangen-Nürnberg
  91054 Erlangen (DE)**

(72) Inventors:
- **Haslach, Christoph
  70178 Stuttgart (DE)**
- **Frotzscher, Andreas
  01640 Coswig (DE)**
- **Markert, Daniel
  70435 Stuttgart (DE)**
- **Yu, Xin
  70435 Stuttgart (DE)**

(74) Representative: **Kleinbub, Oliver et al
Alcatel-Lucent Deutschland AG
Intellectual Property & Standards
Lorenzstrasse 10
70435 Stuttgart (DE)**

(56) References cited:
**US-B2- 7 079 758     US-B2- 7 724 082**

- **HAWKSFORD ET AL: "Modulation and System
  Techniques in PWM and SDM Switching
  Amplifiers", JAES, AES, 60 EAST 42ND STREET,
  ROOM 2520 NEW YORK 10165-2520, USA, vol. 54,
  no. 3, 1 March 2006 (2006-03-01), pages 107-139,
  XP040507759,**

## Description

### Field of the invention

The invention relates to a method for pulse width modulation of an input signal using at least one pulse width modulator, and a transmitter adapted to perform said method.

### Background

In order to support highly efficient switching power amplifiers, signals with continuous amplitude, or multi-level signals, need to be converted to 2-level signals. In general, this transformation is executed by so-called delta sigma modulators (DSM), also called sigma delta modulators, or pulse length modulators (PLM), also called pulse width modulators (PWM).

These so-called pulse width modulators (PWM) are promising modulator concepts in the context of switching amplifiers, e.g. for highly efficient switching power amplifiers used for the amplification of radio signals to be transmitted over an air interface in a communication network. In principle, they allow for an ideal conversion of signals with continuous amplitude and limited bandwidth to a time continuous 2-level signal. This 2-level signal is perfectly suited for switching amplifier stages. The 2-level signal can be reconverted to the continuous amplitude signal simply by a reconstruction filter after the amplification stage.

Further applications of pulse width modulators comprise the control of the supply of electrical power for other devices such as in speed control of electric motors, operation of so-called class D audio switching amplifiers or brightness control of light sources.

In the paper by Hawksford et al. with the title "Modulation and System Techniques in PWM and SDM Switching Amplifiers", JAES, AES, 60 East 42nd Street, Room 2520 New York 10165-2520, USA, a PWM model is disclosed according to which two streams of unit-area pulses are derived from two linear phase modulation (LPM) signals, and the composite data stream of said two streams of unit area pulses is integrated, which translates each unit-area pulse into a unit step function. Thus, as a result a binary or multilevel PWM square wave output is formed. In the US patent US 7,724,082 B2, a method and a system for amplifying an audio signal is disclosed, according to which a pulse code modulation (PCM) audio signal is input to a comparator resulting in a first PWM signal, and the inverted PCM audio signal is input to another comparator resulting in a second PWM signal. The differential output subtracting the second PWM signal from the first PWM signal is then applied to the load.

### Summary

There exist numerous pulse width modulator architectures, but they either suffer from low coding efficiency, spectral deterioration, high sampling frequencies and/or difficulties in implementations. The typical class S setup for radio frequency (RF) applications employing a pulse width modulator looks as follows: an analogue signal is converted to a 2-level signal, e.g. a switching signal, by a pulse width modulator. The resulting signal is amplified by a switching amplifier. The amplified signal is re-converted to a time- and amplitude-continuous signal by a reconstruction filter, which can be a low pass or band pass filter depending on the spectral pureness and the wanted signal band. This filter erases, i.e. attenuates, the out-of-band signal components. If there are many and strong out-of-band signal components, also refered to as quantization noise, this results in strict requirements for the filter characteristics and the termination conditions of this filter. Any non-idealities in these characteristics result in power losses and/or spectral deterioration. Hence, it is important to have a pulse width modulator architecture, that generates a switching signal with a minimum of signal components in the out-of-band region. This means, the coding efficiency of the switching signal, defined as the ratio of the wanted signal power at the carrier frequency and the total signal power, shall be as high as possible.

In principle, an analogue implementation of a pulse width modulator works as described in the following.

A signal with a continuous amplitude is fed to a comparator as a first input signal. The second input signal to the comparator is a sawtooth signal or a triangular signal. In the following only the sawtooth signal is mentioned, but the considerations are valid for triangular signals too. As soon as the ascending amplitude of the sawtooth signal has the same value as the continuous amplitude signal, the output of the comparator switches from voltage-high (VH) to voltage-low (VL). The falling edge of the sawtooth signal resets the output of the comparator to voltage high (VH). The output of the comparator is the PWM signal.

Depending on the implementation, the first input signal of the comparator may also be the sampled version of the continuous amplitude signal, sampled at equidistant time instances.

Simulation results of such a pulse width modulator according to the state of the art for a 5MHz UMTS signal (UMTS = Universal Mobile Telecommunications System) with 5 MHz bandwidth and 5.6dB Peak to Average Power Ratio (PAPR), and with the carrier frequency of the UMTS signal being 900 MHz, and the frequency of the triangular trigger signal, i.e. reference signal, being 1.4 GHz, show that the wanted signal at 900 MHz only contains a small fraction of the total signal power. The majority of signal power is allocated at the first harmonic component of the reference signal at 1.4 GHz. As a consequence, the coding efficiency is only 11.98% in this case.

The object of the invention is thus to propose a method for pulse width modulation that has high coding efficieny, low pulse rates and a simple structure that simplifies implementation and improves energy efficiency.

According to the invention, a 3-level pulse width modulated signal at carrier frequency $f_c$ is generated from an analogue signal at carrier frequency $f_c$, where each positive carrier half wave of the analogue signal at carrier frequency $f_c$ is mapped to a positive pulse and where each negative half wave of the analogue signal at carrier frequency $f_c$ is mapped to a negative pulse of the 3-level pulse width modulated signal. Between positive pulses and negative pulses and between negative pulses and positive pulses, the 3-level pulse width modulated signal is set to 0.

A pulse width modulator generating such a 3-level pulse width modulated signal leads to a spectrum having the majority of the signal power now located at the wanted carrier frequency with the coding efficiency being higher than 60%, compared to 11.98% in a conventional pulse width modulator generating a 2-level pulse width modulated signal for the same analogue input signal.

A key idea of the invention is to represent this ternary signal, i.e. 3-level signal, that may contain very short pulses by two binary signals, i.e. 2-level signals, with a quasi constant duty cycle of 50%, which means that all pulses have nearly the same pulse length.

The key idea can also be interpreted from another point of view:
The ternary signal is generated by combining two binary signals, with the first binary signal setting the pulses and the second signal re-setting the pulses to 0.

In principle the two binary signals are alternating rectangular waveforms with modulated phase.

If the phase is not modulated the two binary signals have a duty cycle of 50%, and the second binary signal is the inverted waveform of the first binary signal. Hence, if the two un-modulated rectangular waveforms are added, they add to 0.

The phase difference of the two binary signals is correlated to the pulse width of the ternary signal, i.e. a higher phase difference of the two binary signals leads to a higher pulse width of the ternary signal. As the pulse width of the ternary signal shall be correlated to the amplitude of the analogue input signal, i.e. a higher amplitude of the analogue input signal shall lead to a higher pulse width of the ternary signal, the phase difference of the two binary signals is correlated to the amplitude of the analogue input signal.

The object is thus achieved by a method according to claim 1. The object is furthermore achieved by a transmitter according to claim 10. Further features and advantages are stated in the following description of exemplary embodiments, with reference to the figures, which shows significant details, and are defined by the claims. The individual features can be implemented individually by themselves, or several of them can be implemented in any desired combination.

**Brief description of the figures**

In the following the invention will be explained further making reference to the attached drawings.

Fig. 1 schematically shows a pulse width modulator according to the state of the art.

Fig. 2 shows a spectrum plot of a power spectral density of a pulse width modulated signal according to the state of the art.

Fig. 3 schematically shows an analogue radio frequency input signal and schematically shows a corresponding 3-level pulse width modulated signal.

Fig. 4 schematically shows the generation of a 3-level pulse width modulated signal by two 2-level pulse width modulated signals without phase modulation.

Fig. 5 schematically shows the generation of a 3-level pulse width modulated signal by two 2-level pulse width modulated signals with phase modulation.

Fig. 6 schematically shows the generation of a 3-level pulse width modulated signal by two 2-level pulse width modulated signals with phase modulation, and the resulting phase of the 3-level pulse width modulated signal.

Fig. 7 schematically shows exemplarily a transmitter for pulse width modulation using two pulse width modulators for modulation of upconverted input signals with a first and a second phase according to an embodiment of the invention.

Fig. 8 schematically shows the generation of a 3-level pulse width modulated signal by two 2-level pulse width modulated signals with phase modulation using the transmitter depicted in fig. 7.

Fig. 9 shows a spectrum plot of a power spectral density of a 3-level pulse width modulated signal as depicted in fig. 8.

Fig. 10 schematically shows exemplarily a transmitter for pulse width modulation using one pulse width modulator for modulation of an upconverted input signal and two variable delay devices according to an embodiment of the invention.

Fig. 11 schematically shows exemplarily a transmitter for pulse width modulation using one pulse width modulator for modulation of an upconverted input signal, a variable delay device, and a fix delay device according to an embodiment of the invention.

Fig. 12 schematically shows exemplarily a transmitter for amplification of distributed 3-level pulse width modulated signals using two pulse width modulators and separate switching power amplifiers according to an embodiment of the invention.

Fig. 13 schematically shows exemplarily a transmitter for amplification of distributed 3-level pulse width modulated signals using two pulse width modulators, an inverter, and a differential switching power amplifier according to an embodiment of the invention.

Fig. 14 schematically shows exemplarily a transmitter for amplification of distributed 3-level pulse width modulated signals using two pulse width modulators, and a differential switching power amplifier according to an embodiment of the invention.

Fig. 15 schematically shows a differential switching power amplifier architecture relying on a voltage switched circuit topology according to the state of the art.

Fig. 16 schematically shows a differential switching power amplifier architecture relying on a current switched circuit topology according to the state of the art.

Fig. 17 schematically shows exemplarily a transmitter for amplification of distributed 3-level pulse width modulated signals using two pulse width modulators, and a H-bridge power amplifier according to an embodiment of the invention.

Fig. 18 schematically shows exemplarily a transmitter for amplification of distributed 3-level pulse width modulated signals using two pulse width modulators, an inverter, a logic circuit, and a differential switching power amplifier according to an embodiment of the invention.

**Description of the embodiments**

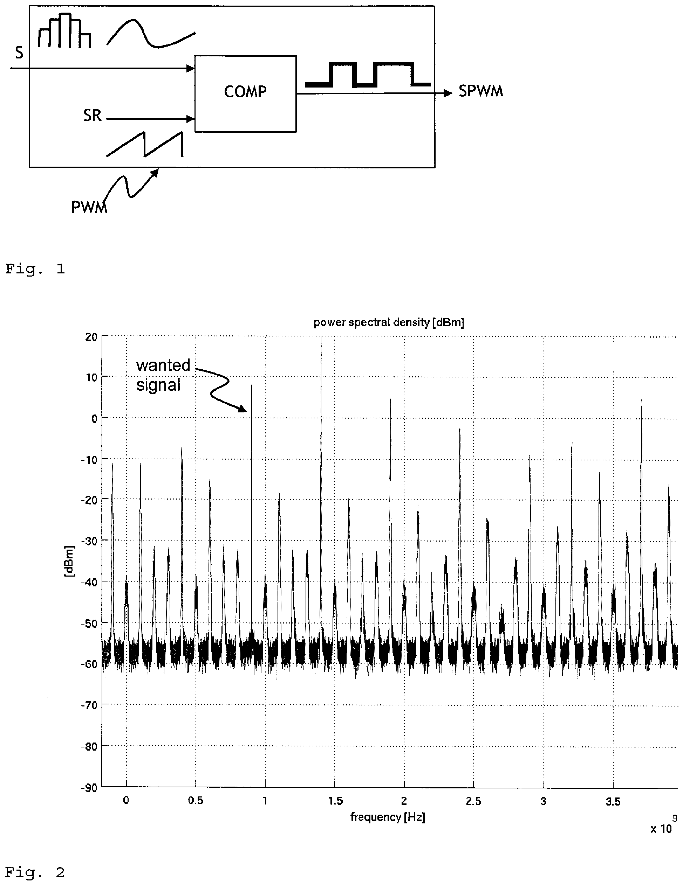

Fig. 1 schematically shows a pulse width modulator PWM according to the state of the art comprising as a basic part a comparator COMP with two inputs and one output.

Depending on the implementation, the input signal S of the pulse width modulator PWM can either be a signal with continuous amplitude, or the sampled version of the continuous amplitude signal, sampled at equidistant time instances.

The input signal S is fed to the first input of the comparator COMP, and a sawtooth signal SR is fed to the second input of the comparator COMP. As soon as the ascending amplitude of the sawtooth signal SR has the same value as the input signal S, the output of the comparator switches from voltage-high (VH) to voltage-low (VL) and remains at VL as long as SR $\geq$ S holds. The falling edge of the sawtooth signal SR resets the output of the comparator to voltage high (VH). The pulse width modulated signal SPWM is transmitted from the output of the comparator COMP to the output of the pulse width modulator PWM.

Fig. 2 shows a simulation of a spectrum plot of a power spectral density of a pulse width modulated signal using the pulse width modulator PWM depicted in fig. 1 for a 5MHz UMTS signal with 5 MHz bandwidth and 5.6dB Peak to Average Power Ratio (PAPR). The carrier frequency of the UMTS signal is 900 MHz, the repetition frequency of a triangular trigger signal, i.e. reference signal, is 1.4 GHz. It can be seen, that the wanted 900 MHz spectral component only contains a small fraction of the total signal power. The majority of signal power is allocated at the first harmonic component of the reference signal at 1.4 GHz. As a consequence, the coding efficiency is only 11.98% in this case.

According to the invention, a 3-level pulse width modulated signal at carrier frequency $f_c$ is generated from an analogue signal at carrier frequency $f_c$, where each positive carrier half wave of the analogue signal at carrier frequency $f_c$ is mapped to a positive pulse and where each negative half wave of the analogue signal at carrier frequency $f_c$ is mapped to a negative pulse of the 3-level pulse width modulated signal. Between positive pulses and negative pulses and between negative pulses and positive pulses, the 3-level pulse width modulated signal is set to 0.

As will be shown below, a pulse width modulator generating such a 3-level pulse width modulated signal leads to a spectrum having the majority of the signal power now located at the wanted carrier frequency with the coding efficiency being higher than 60%, compared to 11.98% in a conventional pulse width modulator generating a 2-level pulse width modulated signal for the same analogue input signal.

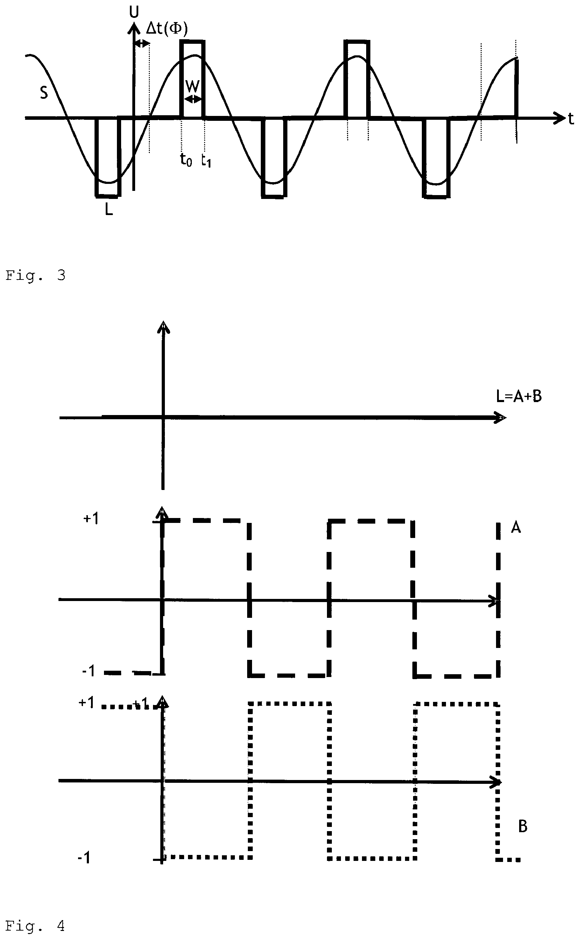

Fig. 3 schematically shows an analogue radio frequency input signal and schematically shows such a corresponding 3-level, i.e. ternary, pulse width modulated signal.

In the diagram in fig. 3, a signal strength of an input signal S=a*sin($2\pi f_c t+\Phi$) is plotted against time t, with a being the envelope of the input signal S, $f_c$ being the carrier frequency, and $\Phi$ being the phase of the input signal S. Additionally, the desired ternary pulse width modulated signal L is depicted which results after mapping each positive carrier half wave of the input signal at carrier frequency $f_c$ to a positive pulse, and mapping each negative half wave of the input signal at carrier frequency $f_c$ to a negative pulse.

A key idea of the invention is to represent this ternary signal that may contain very short pulses by two binary signals with a quasi constant duty cycle of 50%, which means that all pulses have nearly the same pulse length.

The idea can also be interpreted from another point of view:
The ternary signal is generated by combining two signals, where the first signal is setting the pulses and the second signal is re-setting the pulses to 0.

In principle the two signals are alternating rectangular waveforms with modulated phase. If the phase is not modulated the two signals have a duty cycle of 50%, and the second signal is the inverted waveform of the first signal. Hence, if the two un-modulated rectangular waveforms are added, they add to 0.

Fig. 4 schematically shows the generation of such a 3-level pulse width modulated signal by two 2-level pulse width modulated signals without phase modulation.

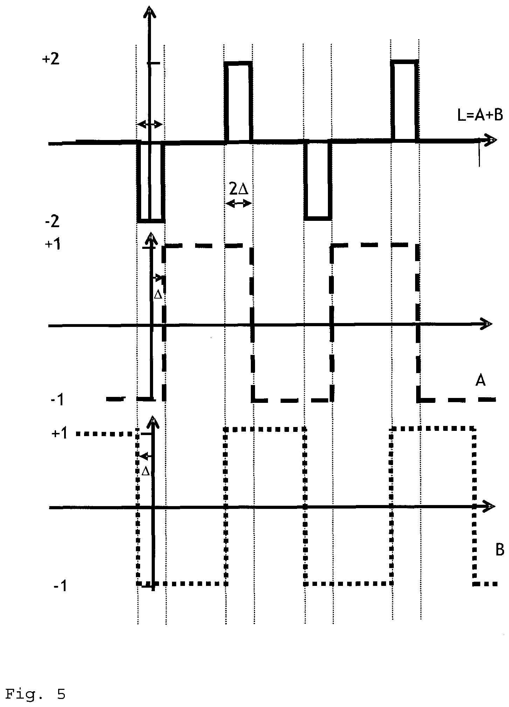

Fig. 5 schematically shows the generation of a 3-level pulse width modulated signal by two 2-level pulse width modulated signals with phase modulation.

In both fig. 4 and fig. 5, the dashed signal A in the diagram in the middle represents the signal that is responsible for setting the pulses. The dotted signal B in the lower diagram is responsible for resetting the pulses. The solid line L in the upper diagram represents the combined signal of the dashed and the dotted signals.

As soon as the dotted signal B switches from +1 to -1 a negative pulse is set.

As soon as the dotted signal B switches from -1 to +1 a positive pulse is set.

As soon as the dashed signal A switches from +1 to -1 a positive pulse is reset to 0.

As soon as the dashed signal A switches from -1 to +1 a negative pulse is reset to 0.

In fig. 4, the dashed and dotted signals have a phase offset of 180°. Hence, the pulses are set and reset to 0 at the same time and no pulses occur after combining.

In fig. 5, the phase of the rectangular waveforms is changed into opposite directions, i.e. the dotted signal B is shifted by phase $+\Delta$, and the dashed signal A is shifted by phase $-\Delta$. After adding the dotted signal B and the dashed signal A, positive and negative pulses L of length $2 \cdot \Delta$ are created. The larger the phase modulation, i.e. the phase shifting of the pulses A and B is, the longer the pulses L that occur in the combined signal are. Applying this principle, the amplitude information of a baseband signal can be mapped to a pulse width, i.e. the amplitude of the baseband signal is mapped to a phase shift of the two rectangular signals A and B where the first signal gets a negative phase shift $-\Delta$ and the second signal gets a positive phase shift $+\Delta$.

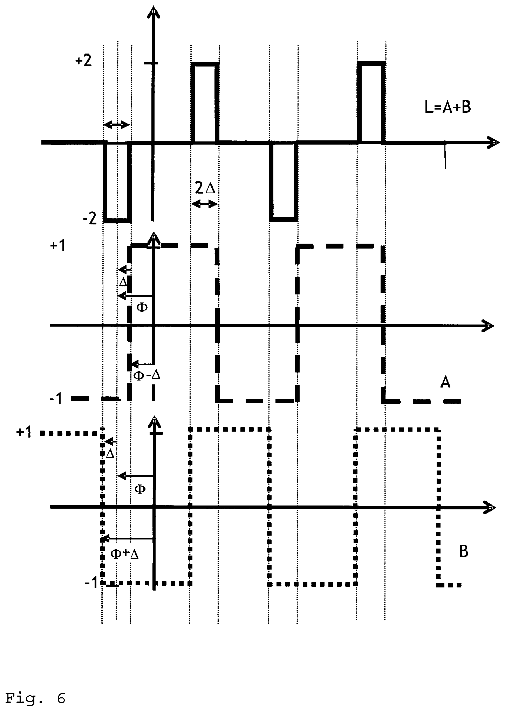

Fig. 6 schematically shows the generation of a 3-level pulse width modulated signal by two 2-level pulse width modulated signals with phase modulation, and the resulting phase of the 3-level pulse width modulated signal.

Again, as in fig. 4 and fig. 5, the dashed signal A in the diagram in the middle represents the signal that is responsible for setting the pulses. The dotted signal B in the lower diagram is responsible for resetting the pulses. The solid line L in the upper diagram represents the combined signal of the dashed and the dotted signals.

The phase information of a baseband signal is mapped to the 3-level pulse width modulated signal L by adding the current phase $\Phi$ of the baseband signal to both rectangular signals A and B, i.e. to both 2-level pulse width modulated signals A and B, in the same direction. This means, that the pulse lengths are not modified by adding the current phase $\Phi$, but the positions of the pulses. Finally, the phase of the rectangular signal A is $\Phi-\Delta$, and the phase of the rectangular signal B is $\Phi+\Delta$, with the amplitude of the baseband signal being mapped to a negative phase shift $-\Delta$ for the rectangular signal A, and to a positive phase shift $+\Delta$ for the rectangular signal B.

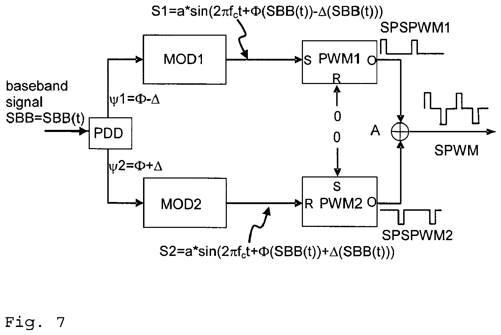

Fig. 7 schematically shows exemplarily a transmitter for pulse width modulation using two pulse width modulators for modulation of upconverted input signals with a first and a second phase as described above under fig. 4, fig. 5 and fig. 6 according to an embodiment of the invention.

The transmitter comprises a phase determination device PDD, a first and a second phase modulator MOD1, MOD2, a first and a second pulse width modulator PWM1, PWM2, and an adder A.

An input signal SBB=SBB(t) on baseband level is evaluated in the phase determination device PDD. The complex-valued input signal SBB=SBB(t) on baseband level is transferred into a first phase $\Psi_1=\Phi-\Delta=\Phi(SBB(t))-\Delta(SBB(t))$ and a second phase $\Psi_2=\Phi+\Delta=\Phi(SBB(t))+\Delta(SBB(t))$ in the phase determination device PDD with

$$\Delta(SBB) = 0.5 \cdot \arcsin\left(\frac{|SBB|}{SBB_{max}}\right)$$

and

$$\Phi(SBB) = phase(SBB).$$

Thus, as described above under fig. 6, $\Phi$ represents the phase of the input signal SBB, and the phase shift $\Delta$ is correlated to the amplitude of the input signal SBB, with $SBB_{max}$ being the maximum allowed value for $|SBB|$, which is the absolute value of the input signal SBB. As the phase shift $\Delta$ determines the pulse width in a following pulse width modulation as described above in fig. 5 and 6, the choice of $SBB_{max}$ determines directly the pulse width.

In an alternative of the embodiment, one or more terms of a Taylor series expansion of the phase shift $\Delta(SBB) = 0.5 \cdot \arcsin\left(\frac{|SBB|}{SBB_{max}}\right)$ can be used as an approximation for determination of the first and the second phase value $\Psi_1$ and $\Psi_2$.

The first and the second phase value $\Psi_1$ and $\Psi_2$ are transmitted from phase determination device PDD to the first and second phase modulator MOD1 and MOD2 respectively.

In the first and second phase modulator MOD1 and MOD2, a first and a second upconverted signal on a carrier frequency $f_c$ is generated. For phase modulation, the first and the second phase $\Psi_1$ and $\Psi_2$ respectively are used.

Thus, the first upconverted signal on the carrier frequency $f_c$ generated in the first phase modulator MOD1 is $S1=a\cdot\sin(2\pi f_c t+\Phi(SBB(t))-\Delta(SBB(t)))$, and the second upconverted signal on the carrier frequency $f_c$ generated in the second phase modulator MOD2 is $S2=a.\sin(2\pi f_c t+\Phi(SBB(t))+\Delta(SBB(t)))$, with $a$ being a constant.

The first upconverted signal S1 is transmitted to a signal input of the first pulse width modulator PWM1, and a first comparator threshold at level 0 is fed to a reference input of the first pulse width modulator PWM1.

The second upconverted signal S2 is transmitted to a reference input of the second pulse width modulator PWM2, and a second comparator threshold at level 0 is fed to a signal input of the second pulse width modulator PWM2.

The first and second pulse width modulators MOD1 and MOD2 have a functionality as e.g. described above under fig. 1 with the difference, that as a reference signal not a sawtooth signal, but a constant comparator threshold at level 0 is used. Furthermore, the input signals of the second pulse width modulator PWM2 are exchanged, i.e. the reference signal input, marked with R in fig. 7, and the desired signal input, marked with S in fig. 7, of the second pulse width modulator PWM2 are exchanged with each other, which is equivalent to an inversion of a respective phase shifted pulse width modulated signal SPSPWM2.

If the first upconverted signal S1 at the signal input S of the first pulse width modulator PWM1 is larger than the reference signal at the reference signal input R, the output signal of the first pulse width modulator PWM1, i.e. a first phase shifted pulse width modulated signal SPSPWM1, is "+1", otherwise, the output signal of the first pulse width modulator PWM1 is "-1".

If the reference signal at the signal input S of the second pulse width modulator PWM2 is larger than the second upconverted signal S2 at the reference signal input R, the output signal of the second pulse width modulator PWM2, i.e. a second phase shifted pulse width modulated signal SPSPWM2, is "+1", otherwise, the output signal of the second pulse width modulator PWM2 is "-1".

In other words, the first and second pulse width modulators PWM1 and PWM2 map phase modulated sinusoidal waveforms, i.e. the first and second upconverted signal S1 and S2, to phase modulated rectangular waveforms, i.e. to the first and second phase shifted pulse width modulated signal SPSPWM1 and SPSPWM2.

In an embodiment of the invention, instead of exchanging the reference signal input, marked with R in fig. 7, and the desired signal input, marked with S in fig. 7, of the second pulse width modulator PWM2, an inverter for signal inversion can be inserted in the path between the second phase modulator MOD2 and the second pulse width modulator PWM2.

The first phase shifted pulse width modulated signal SPSPWM1, and the second phase shifted pulse width modulated signal SPSPWM2 are added in the adder A resulting in a ternary pulse width modulated signal SPWM.

In embodiments of the invention, the first and second pulse width modulators PWM1 and PWM2 may be implemented as a dedicated comparator, or as a limiting amplifier with differential input ports.

In an alternative, but equivalent embodiment, the first and second pulse width modulators PWM1 and PWM2 have a binary output alphabet with values '0' and '1' and the output of the second pulse width modulator PWM2 is subtracted from the output of the first pulse width modulator PWM1.

It should be noted, that the values "+1","0" and "-1" have a symbolic meaning here. The levels may e.g. represent voltages, with "+1" and "-1" representing two different voltages, and "0" representing the sum of these two voltages.

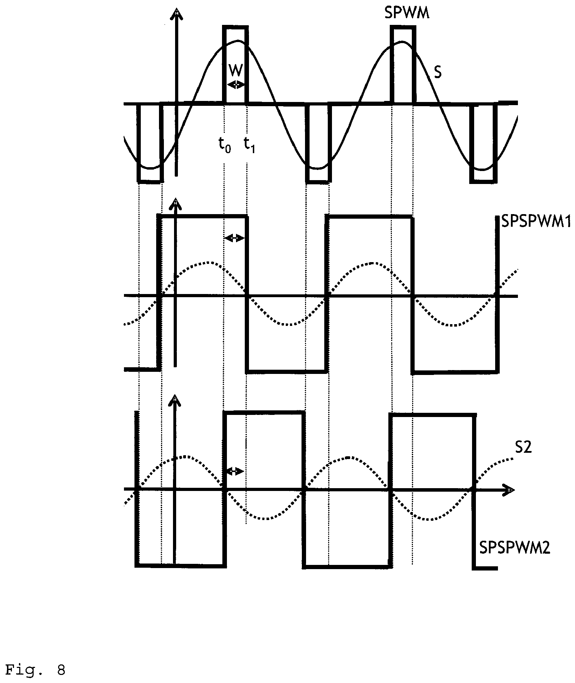

Fig. 8 schematically shows the generation of a 3-level pulse width modulated signal by two 2-level pulse width modulated signals with phase modulation using the transmitter depicted in fig. 7. Thus, the depicted signals in fig. 8 in principle show how the transmitter in fig. 7 works.

The first signal diagram in fig. 8 shows an upconverted signal $S=|SBB|\cdot\sin(2\pi f_c t+\Phi)$ on carrier frequency $f_c$, and how the wanted ternary pulse width modulated signal SPWM looks like. The ternary pulse width modulated signal SPWM has one pulse per carrier half wave, with the pulse width W depending on the envelope amplitude of the carrier signal.

The second signal diagram shows the output of the first pulse width modulator PWM1, i.e. the first phase shifted pulse width modulated signal SPSPWM1. The dotted sinusoidal waveform represents the output of the first phase modulator MOD1, i.e. the first upconverted signal S1. As soon as the first upconverted signal S1 intersects the 0-level, the output of the first pulse width modulator PWM1 is changed. A positive sinusoidal half wave causes a positive rectangular pulse, and a negative sinusoidal half wave causes a negative rectangular pulse.

The third signal diagram shows the output of the second pulse width modulator PWM2, i.e. the second phase shifted pulse width modulated signal SPSPWM2. The dotted sinusoidal waveform represents the output of the second phase modulator MOD2, i.e. the second upconverted signal S2. As soon as the second upconverted signal S2 intersects the 0-level, the output of the comparator is changed. A positive sinusoidal half wave causes a negative rectangular pulse, and a negative sinusoidal half wave causes a positive rectangular pulse. The behaviour of the second pulse width modulator PWM2 seems inverted to the behaviour of the first pulse width modulator PWM1. This results from the fact, that for the first pulse width modulator PWM1, the 0-signal is connected to the reference signal input R, while for the second pulse width modulator PWM2, the 0-signal is connected to the desired signal input S.

Adding the first and second phase shifted pulse width modulated signals SPSPWM1 and SPSPWM2 results in the wanted ternary pulse width modulated signal SPWM depicted in the first signal diagram.

The signal diagrams in fig. 8 illustrate a key feature of the pulse width modulation according to the embodiment of the invention. The upconverted signals S1 and S2 as input signals of the first and second pulse width modulators PWM1 and PWM2 are sinusoidal signals with constant envelope. Only the phase of said upconverted signals S1 and S2 is modulated. The output signals of the first and second pulse width modulators PWM1 and PWM2 are switching rectangular pulses with modulated phase. If the bandwidth of the baseband signal SBB is small compared to the carrier frequency, which is the typical case in most radio systems, the phase modulation is very slow compared to the frequency of the pulses. This means, that first and second pulse width modulators PWM1 and PWM2 yield rectangular pulses with a duty cycle which is close to 50%. This is a substantial advantage of this approach, as one can assume that these simple signal waveforms can be handled by the components in a much better way than other signals, e.g. with a high peak to average power ratio or signals with strongly varying duty cycles.

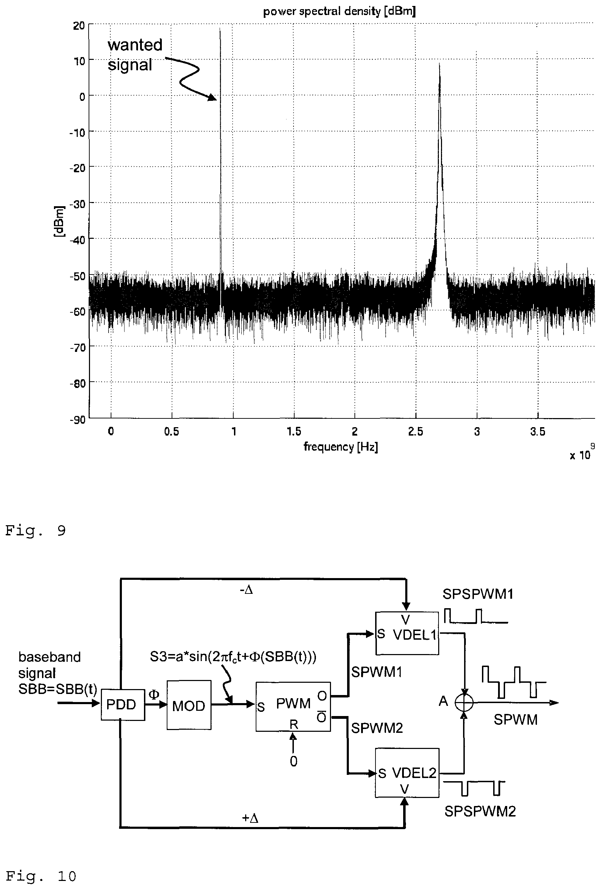

Fig. 9 shows a spectrum plot of a power spectral density of the ternary pulse width modulated signal SPWM as depicted in fig. 8.

The spectrum plot shows simulation results for the spectrum of the final outcome of the transmitter depicted in fig. 7, i.e. of the ternary pulse width modulated signal SPWM after the adder A, for a signal at a carrier frequency of 900 MHz. It is obvious that the majority of the signal power is now located at the wanted carrier frequency. Now, the coding efficiency is higher than 60%, compared to 11.98% in the conventional pulse width modulator depicted in fig. 1 for the same input signal. Further advantages are that the requirements for a subsequent reconstruction filter can be relaxed significantly, as the quantization noise power is drastically reduced, and that the spectrum in the vicinity of the carrier frequency is much cleaner. Furthermore, the spectrum from DC to $3*f_c$ does not show any unwanted spectral emissions.

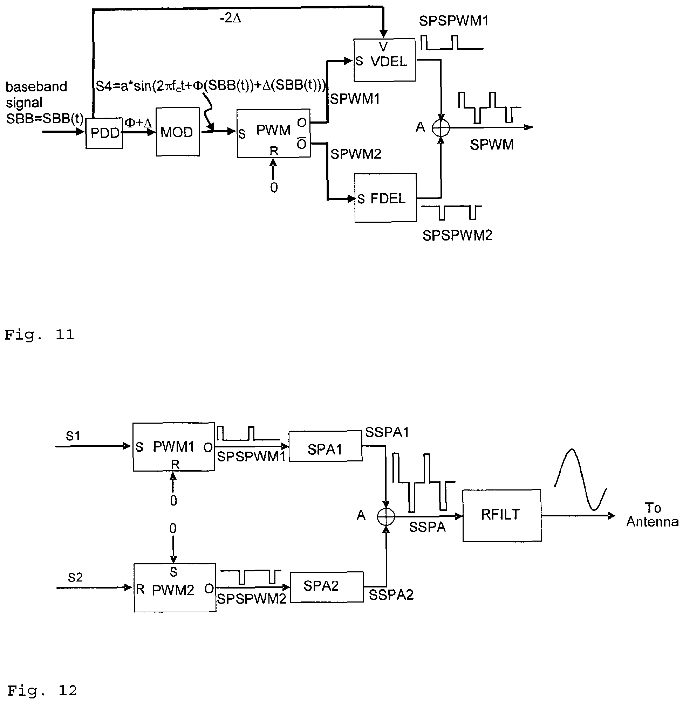

In embodiments of the invention described in the following under fig. 10 and fig. 11, the positive phase shift $+\Delta$ and the negative phase shift $-\Delta$ as given above

under figs. 6 and 7 are added after the pulse width modulation is performed.

Fig. 10 schematically shows exemplarily a transmitter for pulse width modulation using one pulse width modulator for modulation of an upconverted signal and two variable delay devices according to an embodiment of the invention.

The transmitter comprises a phase determination device PDD, a phase modulator MOD, a pulse width modulator PWM, a first and a second variable delay device VDEL1 and VDEL2, and an adder A.

An input signal SBB=SBB(t) on baseband level is evaluated in the phase determination device PDD. The complex-valued input signal SBB=SBB(t) on baseband level is transferred into a positive phase shift $+\Delta$, a negative phase shift $-\Delta$, and a phase $\Phi$ of the input signal SBB in the phase determination device PDD with

$$\Delta(SBB) = 0.5 \cdot \arcsin\left(\frac{|SBB|}{SBB_{max}}\right)$$

and

$$\Phi(SBB) = phase(SBB).$$

Thus, as described above under fig. 6, $\Phi$ represents the phase of the input signal SBB, and the phase shift $\Delta$ is correlated to the amplitude of the input signal SBB, with $SBB_{max}$ being the maximum allowed value for $|SBB|$, which is the absolute value of the input signal SBB. As the phase shift $\Delta$ determines the pulse width in a following pulse width modulation as described above in fig. 5 and 6, the choice of $SBB_{max}$ determines directly the pulse width.

The phase $\Phi$ of the input signal SBB is transmitted from phase determination device PDD to the phase modulator MOD.

In the phase modulator MOD, an upconverted signal on a carrier frequency $f_c$ is generated. For phase modulation, the phase $\Phi$ of the input signal SBB is used.

Thus, the upconverted signal on the carrier frequency $f_c$ generated in the phase modulator MOD is $S3=a \cdot \sin(2\pi f_c t + \Phi(SBB(t)))$, with a being a constant.

The upconverted signal S3 is transmitted to a signal input of the pulse width modulator PWM, and a comparator threshold at level 0 is fed to a reference input of the pulse width modulator PWM.

The pulse width modulator MOD has a functionality as e.g. described above under fig. 1 with the difference, that as a reference signal not a sawtooth signal, but a constant comparator threshold at level 0 is used. Furthermore, the pulse width modulator MOD comprises two outputs $O$ and $\overline{O}$ for output of a first pulse width modulated signal SPWM1, and for output of a second pulse width modulated signal SPWM2, which corresponds to the inverted first pulse width modulated signal SPWM1.

If the upconverted signal S3 at the signal input S of the pulse width modulator PWM is larger than the reference signal at the reference signal input R, the output signal of the pulse width modulator PWM at the output O, i.e. the first pulse width modulated signal SPWM1, is "+1", otherwise, the output signal of the pulse width modulator PWM at the output O is "-1".

The output signal of the pulse width modulator PWM at the output $\overline{O}$, i.e. the second pulse width modulated signal SPWM2, corresponds to the inverted first pulse width modulated signal SPWM1.

In other words, the pulse width modulator PWM maps phase modulated sinusoidal waveforms, i.e. the upconverted signal S3, to phase modulated rectangular waveforms, i.e. to the first and second pulse width modulated signal SPWM1 and SPWM2.

The first pulse width modulated signal SPWM1 is transmitted to a signal input of the first variable delay device VDEL1, and the second pulse width modulated signal SPWM2 is transmitted to a signal input of the second variable delay device VDEL2.

The positive phase shift +Δ is transmitted from the phase determination device PDD to a delay input of the second variable delay device VDEL2, and the negative phase shift -Δ is transmitted from the phase determination device PDD to a delay input of the first variable delay device VDEL1.

In the first and second variable delay devices VDEL1 and VDEL2, a negative and positive delay respectively is added to the first and second pulse width modulated signal SPWM1 and SPWM2 respectively, which corresponds to a phase shift -Δ and +Δ respectively at carrier frequency $f_c$, and results in a first and a second phase shifted pulse width modulated signal SPSPWM1 and SPSPWM2 respectively.

The first phase shifted pulse width modulated signal SPSPWM1, and the second phase shifted pulse width modulated signal SPSPWM2 are added in the adder A resulting in a ternary pulse width modulated signal SPWM.

In an alternative, but equivalent embodiment, the pulse width modulator PWM has a binary output alphabet with values '0' and '1' and the output of the second variable delay device VDEL2 is subtracted from the output of the first variable delay device VDEL1.

It should be noted, that the values "+1","0" and "-1" have a symbolic meaning here. The levels may e.g. represent voltages, with "+1" and "-1" representing two different voltages, and "0" representing the sum of these two voltages.

Fig. 11 schematically shows exemplarily a transmitter for pulse width modulation using one pulse width modulator for modulation of an upconverted signal, a variable delay device, and a fix delay device according to an embodiment of the invention.

The transmitter comprises a phase determination device PDD, a phase modulator MOD, a pulse width modulator PWM, a variable delay device VDEL, a fix delay device FDEL, and an adder A.

An input signal SBB=SBB(t) on baseband level is evaluated in the phase determination device PDD. The complex-valued input signal SBB=SBB(t) on baseband level is transferred into a positive phase shift +Δ, a negative phase shift -2Δ, and a phase Φ of the input signal SBB in the phase determination device PDD with

$$\Delta(SBB) = 0.5 \cdot \arcsin\left(\frac{|SBB|}{SBB_{max}}\right)$$

and

$$\Phi(SBB) = phase(SBB).$$

Thus, as described above under fig. 6, Φ represents the phase of the input signal SBB, and the phase shift Δ is correlated to the amplitude of the input signal SBB, with $SBB_{max}$ being the maximum allowed value for $|SBB|$, which is the absolute value of the input signal SBB. As the phase shift Δ determines the pulse width in a following pulse width modulation as described above in fig. 5 and 6, the choice of $SBB_{max}$ determines directly the pulse width.

The phase Φ and the phase shift Δ of the input signal SBB are transmitted from the phase determination device PDD to the phase modulator MOD.

In the phase modulator MOD, an upconverted signal on a carrier frequency $f_c$ is generated. For phase modulation, the sum Φ + Δ of the phase Φ and the phase shift Δ of the input signal SBB is used.

Thus, the upconverted signal on the carrier frequency $f_c$ generated in the phase modulator MOD is S4 = $a \cdot \sin(2\pi f_c t + \Phi(SBB(t)) + \Delta(SBB(t)))$, with $a$ being a constant.

The upconverted signal S4 is transmitted to a signal input of the pulse width modulator PWM, and a comparator threshold at level 0 is fed to a reference input of the pulse width modulator PWM.

The pulse width modulator MOD has a functionality as e.g. described above under fig. 1 with the difference, that as a reference signal not a sawtooth signal, but a constant comparator threshold at level 0 is used. Furthermore, the pulse width modulator MOD comprises two outputs O and $\overline{O}$ for output of a first pulse width modulated signal SPWM1, and for output of a second pulse width modulated signal SPWM2, which corresponds to the inverted first pulse width modulated signal SPWM1.

If the upconverted signal S4 at the signal input S of the pulse width modulator PWM is larger than the reference signal at the reference signal input R, the output signal of the pulse width modulator PWM at the output O, i.e. the first pulse width modulated signal SPWM1, is "+1", otherwise, the output signal of the pulse width modulator PWM at the output O is "-1".

The output signal of the pulse width modulator PWM at the output $\overline{O}$, i.e. the second pulse width modulated signal SPWM2, corresponds to the inverted first pulse width modulated signal SPWM1.

In other words, the pulse width modulator PWM maps phase modulated sinusoidal waveforms, i.e. the upconverted signal S4, to phase modulated rectangular waveforms, i.e. to the first and second pulse width modulated signal SPWM1 and SPWM2.

The first pulse width modulated signal SPWM1 is transmitted to a signal input of the variable delay device VDEL, and the second pulse width modulated signal SPWM2 is transmitted to a signal input of the fix delay device FDEL.

The negative phase shift -2Δ is transmitted from the phase determination device PDD to a delay input of the variable delay device VDEL.

In the variable delay device VDEL, a negative delay is added to the first pulse width modulated signal SPWM1, which corresponds to a phase shift -2Δ at carrier frequency $f_c$, and results in a first phase shifted pulse width modulated signal SPSPWM1.

In the fix delay devices FDEL, a default delay is added to the second pulse width modulated signal SPWM2, which corresponds to a default delay that is inserted in the variable delay device VDEL, if the input signal to the delay input of the variable delay device VDEL has the value -2Δ=0, and results in a second phase shifted pulse width modulated signal SPSPWM2.

The first phase shifted pulse width modulated signal SPSPWM1, and the second phase shifted pulse width modulated signal SPSPWM2 are added in the adder A resulting in a ternary pulse width modulated signal SPWM.

In an alternative, but equivalent embodiment, the pulse width modulator PWM has a binary output alphabet with values '0' and '1' and the output of the fix delay device FDEL is subtracted from the output of the variable delay device VDEL.

It should be noted, that the values "+1","0" and "-1" have a symbolic meaning here. The levels may e.g. represent voltages, with "+1" and "-1" representing two different voltages, and "0" representing the sum of these two voltages.

If a reconstruction filter at the wanted carrier frequency $f_c$ is applied to the ternary pulse width modulated signal SPWM in figs 7, 10, and 11, the wanted radio signal $S = |SBB| \cdot sin(2\pi f_c t + \Phi)$ results.

Hence, inserting a switching power amplifier stage between the pulse width modulators PWM1, PWM2, PWM in figs. 7, 10 and 11, and a subsequent reconstruction filter allows for energy efficient power amplification of the radio signal S.

In the following, several embodiments for amplification of a ternary pulse width modulated signal SPWM are given.

Fig. 12 schematically shows exemplarily a transmitter for amplification of distributed 3-level pulse width modulated signals using two pulse width modulators and separate switching power amplifiers according to an embodiment of the invention.

The transmitter comprises a first and a second pulse width modulator PWM1, PWM2, a first and a second switching power amplifier SPA1, SPA2, an adder A, and a reconstruction filter RFILT.

A first upconverted signal S1, as e.g. described above in fig. 7, is transmitted to a signal input of the first pulse width modulator PWM1, and a first comparator threshold at level 0 is fed to a reference input of the first pulse width modulator PWM1.

A second upconverted signal S2, as e.g. described above in fig. 7, is transmitted to a reference input of the second pulse width modulator PWM2, and a second comparator threshold at level 0 is fed to a signal input of the second pulse width modulator PWM2.

The first and second pulse width modulators PWM1 and PWM2 map phase modulated sinusoidal waveforms, i.e. the first and second upconverted signal S1 and S2, to phase modulated rectangular waveforms, i.e. to the first and second phase shifted pulse width modulated signal SPSPWM1 and SPSPWM2 as described above under fig. 7.

The first phase shifted pulse width modulated signal SPSPWM1 is transmitted to an input of the first switching power amplifier SPA1, and the second phase shifted pulse width modulated signal SPSPWM2 is transmitted to an input of the second switching power amplifier SPA2.

In the first switching power amplifier SPA1, said first phase shifted pulse width modulated signal SPSPWM1, which is a binary pulse width modulated signal, is amplified resulting in an amplified copy SSPA1 of the first phase shifted pulse width modulated signal SPSPWM1.

In the second switching power amplifier SPA2, said second phase shifted pulse width modulated signal SPSPWM2, which is a binary pulse width modulated signal, is amplified resulting in an amplified copy SSPA2 of the second phase shifted pulse width modulated signal SPSPWM2.

The amplified copy SSPA1 of the first phase shifted pulse width modulated signal SPSPWM1, and the amplified copy SSPA2 of the second phase shifted pulse width modulated signal SPSPWM2 are added in the adder A resulting in a ternary signal SSPA.

The ternary signal SSPA is then filtered in the reconstruction filter RFILT preferably of low pass or band pass type for extracting the wanted amplified analog inband signal components of the ternary signal SSPA. Said ternary signal SSPA corresponds to an amplified copy of a ternary pulse width modulated signal as e.g. depicted in fig. 7.

Thus, according to the embodiment of the invention the two output signals of the two pulse width modulators SPSPWM1 and SPSPWM2 are amplified separately in two switching power amplifiers SPA1 and SPA2, as it is easier to amplify binary pulse width modulated signals than ternary pulse width modulated signals.

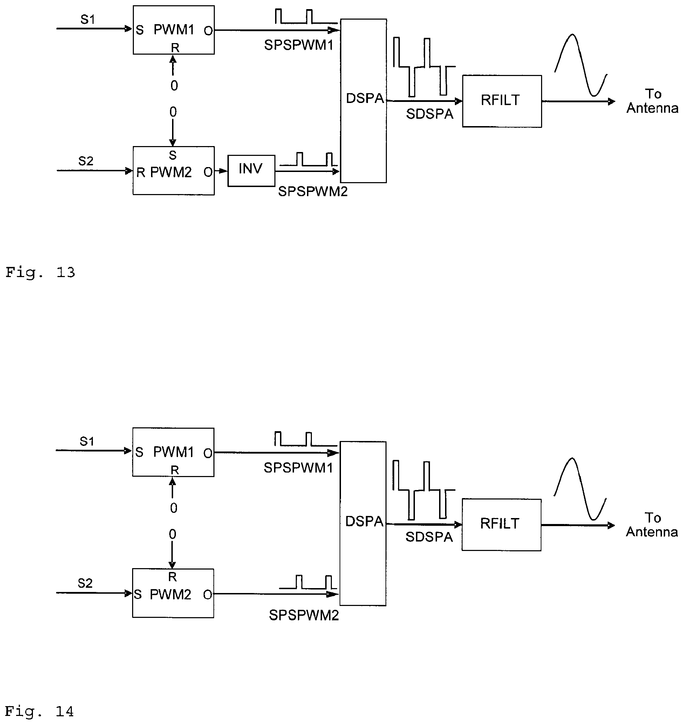

Fig. 13 schematically shows exemplarily a transmitter for amplification of distributed 3-level pulse width modulated signals using two pulse width modulators, an inverter, and a differential switching power amplifier according to an embodiment of the invention.

The transmitter comprises a first and a second pulse width modulator PWM1, PWM2, a signal inverter INV, a differential switching power amplifier DSPA, and a reconstruction filter RFILT.

A first upconverted signal S1, as e.g. described above in fig. 7, is transmitted to a signal input of the first pulse width modulator PWM1, and a first comparator threshold at level 0 is fed to a reference input of the first pulse width modulator PWM1.

A second upconverted signal S2, as e.g. described above in fig. 7, is transmitted to a reference input of the second pulse width modulator PWM2, and a second comparator threshold at level 0 is fed to a signal input of the second pulse width modulator PWM2.

The first and second pulse width modulators PWM1 and PWM2 map phase modulated sinusoidal waveforms, i.e. the first and second upconverted signal S1 and S2, to phase modulated rectangular waveforms, i.e. to the first and second phase shifted pulse width modulated signal SPSPWM1 and SPSPWM2 as described above under fig. 7.

The first phase shifted pulse width modulated signal SPSPWM1 is transmitted to a first input of the differential switching power amplifier DSPA, and the second phase shifted pulse width modulated signal SPSPWM2 is first inverted in the signal inverter INV, and then transmitted to a second input of the differential switching power amplifier DSPA.

In the embodiment depicted in fig. 13, for amplification of the two binary pulse width modulated signals, the differential switching power amplifier DSPA is used. The two inputs of the differential switching power amplifier DSPA are fed with the first phase shifted pulse width modulated signal SPSPWM1, and with the second phase shifted pulse width modulated signal SPSPWM2. Due to the differential operation, the differential switching power amplifier DSPA amplifies separately the two inputs and inherently subtracts them. Thus, for this approach, one of the pulse width modulated output signals needs to be inverted, which is the reason that the binary pulse width modulated signal resulting from the second pulse width modulator PWM2 must be inverted in the signal inverter INV.

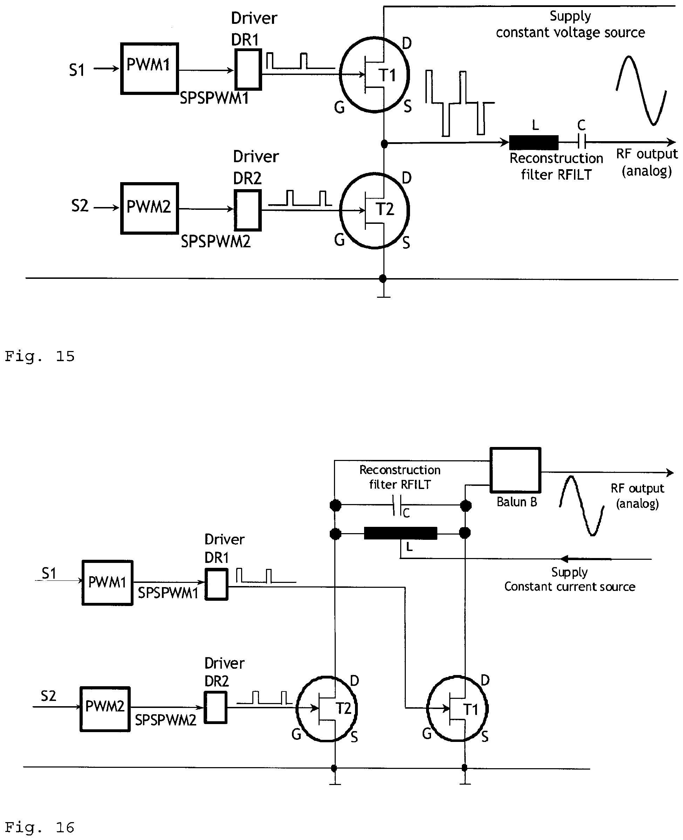

Two examples for an implementation of such a differential switching power amplifier are depicted in figs. 15 and 16, and described below.

The amplification of the first phase shifted pulse width modulated signal SPSPWM1, and the second phase shifted pulse width modulated signal SPSPWM2 results in a ternary signal SDSPA. Said ternary signal SDSPA corresponds to an amplified copy of a ternary pulse width modulated signal as e.g. depicted in fig. 7.

The ternary signal SDSPA is then filtered in a reconstruction filter RFILT preferably of low pass or band pass type for converting the ternary signal SDSPA into an analogue signal.

Thus, according to the embodiment of the invention, the two output signals of the two pulse width modulators PWM1 and PWM2 are amplified in a differential switching power amplifier DSPA, as this is easier than a direct amplification of ternary pulse width modulated signals.

In an embodiment of the invention using a differential switching power amplifier DSPA for amplification of two binary pulse width modulated signals depicted in fig. 14, instead of introducing an inverter, the input signals of one pulse width modulator PWM1 or PWM2 can be exchanged, i.e. the reference signal input, marked with R in fig. 14, and the desired signal input, marked with S in fig. 14, of one pulse width modulator PWM1 or PWM2 are exchanged with each other, which is equivalent to an inversion of the respective pulse width modulated signal.

Thus, the transmitter depicted in fig. 14 in principle corresponds to the transmitter depicted in fig. 13, with the difference, that no inverter INV is used, but instead the inputs for the input signal S and the reference signal R of the second pulse width modulator PWM2 are exchanged.

In an alternative of the embodiment, in case the pulse width modulators PWM1 and PWM2 provide differential outputs, the inverted output of one pulse width modulator PWM1 or PWM2 can be used instead of exchanging its input ports.

Fig. 15 schematically shows a differential switching power amplifier architecture relying on a voltage switched circuit topology according to the state of the art.

In fig. 15, the principle concept of a differential switching power amplifier system according to the state-of-the-art based on voltage switching is shown exemplarily, which can in principle be used in the respective embodiments described above and below in figs. 13, 14 and 18. Said differential switching power amplifier system comprises a first and a second pulse width modulator PWM1, PWM2 with inputs for reception of a first and a second upconverted signal S1 and S2 respectively. An output of the first and the second pulse width modulator PWM1 and PWM2 respectively is connected to an input of a first and a second driver DR1 and DR2 respectively.

An output of the driver DR1 is connected to a gate of a first transistor T1, and an output of the driver DR2 is connected to a gate of a second transistor T2.

A source of the first transistor T1 is connected to ground, and a source of the second transistor T2 is connected to a drain of the first transistor T1.

The drain of the first transistor T1 and the source of the second transistor T2 are connected to an RF output via a reconstruction filter RFILT that comprises an inductor L and a capacitor C in series. There are variants of the L-C filter topology which however are of no importance for the invention as disclosed.

A drain of the second transistor T2 is connected to a supply of a constant voltage source.

In a method for signal amplification using a differential voltage switching power amplifier system according to the state-of-the-art as shown in fig. 15, a first and a second upconverted signal S1 and S2 are sent to the pulse width modulators PWM1 and PWM2 respectively.

In the pulse width modulators PWM1 and PWM2, the first and the second upconverted signal S1 and S2 are converted into a first and a second binary phase shifted pulse width modulated signal SPSPWM1 and SPSPWM2 respectively as described above under fig. 7 by means of using a so-called sample-and-hold output. The first and second binary phase shifted pulse width modulated signal SPSPWM1 and SPSPWM2 respectively with binary amplitude levels is provided at the output of the pulse width modulator PWM1 and PWM2 respectively.

Said first and second binary phase shifted pulse width modulated signals SPSPWM1 and SPSPWM2 are sent to the driver DR1 and DR2 respectively. The driver DR1 generates first driver signals based on the first binary phase shifted pulse width modulated signal SPSPWM1, and the driver DR2 generates second driver signals based on inverting the second binary phase shifted pulse width modulated signal SPSPWM2.

In an alternative, instead of inverting the second binary phase shifted pulse width modulated signal SPSPWM2, the reference signal input, and the desired signal input of the second pulse width modulator PWM2 are exchanged as described under fig. 14.

The first driver signals are sent to the gate of the first transistor T1, and the second driver signals are sent to the gate of the second transistor T2. If the output signal of the first driver DR1 is low, and the output signal of the second driver DR2 is high, then the voltage at the source of the second transistor T2, and at the drain of the first transistor T1 respectively is high, i.e. $V_h$. If the output signal of the first driver DR1 is high, and the output signal of the second driver DR2 is low, then the voltage at the source of the second transistor T2, and at the drain of the first transistor T1 respectively is low, i.e. $V_l$. If the output signal of both the first driver DR1 and the second driver DR2 is low, then the voltage at the source of the second transistor T2, and at the drain of the first transistor T1 respectively is $(V_h+V_l)/2$.

The described amplifier architecture with two transistors T1, T2 is just an example, and in alternative architectures, more than two transistors are used, which has however no influence on the invention. Such alternative architectures are e.g. multibit architectures, using two transistors more per each bit more.

The capacitor C and the inductor L together build exemplarily a reconstruction filter RFILT used to generate from amplified ternary pulse width modulated signals smooth analogue output signals that are provided at the RF output.

Fig. 16 schematically shows a differential switching power amplifier architecture relying on a current switched circuit topology according to the state of the art.

In fig. 16, a differential switching power amplifier system according to the state-of-the-art based on current switching is shown, which can in principle be used in the respective embodiments described above and below in figs. 13, 14 and 18. Said differential switching power amplifier system comprises a first and a second pulse width modulator PWM1, PWM2 with inputs for reception of a first and a second upconverted signal S1 and S2 respectively. An output of the first and the second pulse width modulator PWM1 and PWM2 respectively is connected to an input of a first and a second driver DR1 and DR2 respectively.

An output of the driver DR1 is connected to the gate of a first transistor T1, and an output of the driver DR2 is connected to the gate of a second transistor T2.

Both a source of the first transistor T1 and a source of the second transistor T2 are connected to ground.

A drain of the first transistor T1 is connected to a first input of an inductor L and to a first input of a capacitor C, and a drain of the second transistor T2 is connected to a second input of the inductor L and to a second input of the capacitor C. The capacitor C and the inductor L build together a reconstruction filter RFILT. There are variants of the L-C filter topology which however are of no importance for the invention as disclosed.

A supply of a constant current source is connected to a third input of the inductor L.

Furthermore, the drain of the first transistor T1 is connected to a first input of a balun B, and the drain of the second transistor T2 is connected to a second input of the balun B. The balun B transforms a balanced input signal to a single ended signal. At the balun's output an analogue RF output signal is provided.

Preferably, the drivers DR1, DR2 and the transistors T1 and T2 are fabricated in Gallium Nitride (GaN) technology.

In a method for signal amplification using a differential current switching power amplifier system according to the state-of-the-art as shown in fig. 16, the first and the second upconverted signal S1 and S2 are sent to the pulse width modulators PWM1 and PWM2 respectively.

In the pulse width modulators PWM1 and PWM2, the first and the second upconverted signal S1 and S2 respectively are converted into a first and a second binary phase shifted pulse width modulated signal SPSPWM1 and SPSPWM2 respectively as described above under fig. 7 by means of using a so-called sample-and-hold output. The first and second binary phase shifted pulse width modulated signal SPSPWM1 and SPSPWM2 respectively is provided at the output of the pulse width modulator PWM1 and PWM2 respectively.

Said first and second binary phase shifted pulse width modulated signals SPSPWM1 and SPSPWM2 are sent to the driver DR1 and DR2 respectively. The driver DR1 generates first driver signals based on the first binary pulse width modulated signal SPWM1, and the driver DR2 generates second driver signals based on inverting the second phase shifted binary pulse width modulated signal SPSPWM2.

In an alternative, instead of inverting the second binary phase shifted pulse width modulated signal SPSPWM2, the reference signal input, and the desired signal input of the second pulse width modulator PWM2 are exchanged as described under fig. 14.

The first driver signals are sent to the gate of the first transistor T1, and the second driver signals are sent to the gate of the second transistor T2. The signal generation by means of the first and second transistor T1 and T2 is similar as described above under fig. 15. The described amplifier architecture with two transistors T1, T2 is just an example, and in alternative architectures, more than two transistors are used, which has however no influence on the invention. Such alternative architectures are e.g. multibit architectures, using two transistors more per each bit more.

In the first transistor T1 and in the second transistor T2, the first driver signals and the second driver signals respectively are amplified resulting in first and a second amplifier signals.

The capacitor C and the inductor L build together an exemplary reconstruction filter RFILT used to generate smooth analogue signals out of the first and the second amplifier signals.

The smoothed first and second analogue signals are sent to the balun B, in which the smoothed first and second analogue signals are added together, thus removing DC distortions that have been picked up along the way. In other words, the balun B converts balanced signals to unbalanced signals. The unbalanced RF output signals are provided at the output of the balun B.

Using a differential switching power amplifier as described above has several advantages in comparison to the approach of separate amplification of the two pulse width modulated signals SPWM1 and SPWM2 using separate switching power amplifiers. Since only one switching power amplifier is used, it achieves higher energy efficiency.

The upper and lower single pulse width modulators PWM1 and PWM2 switch on and off the respective switching transistors T1 and T2 of the differential switching power amplifier e.g. depicted in fig. 15 or 16. In general, transfer characteristics, i.e. the different states, of a differential switching power amplifier are given by the following table.

| State | SPWM1 | SPWM2 | SDSPA |
|-------|-------|-------|-------|
| 1 | $V_L$ | $V_L$ | $(V_L + V_H)/2$ |
| 2 | $V_L$ | $V_H$ | $V_L$ |
| 3 | $V_H$ | $V_L$ | $V_H$ |
| 4 | $V_H$ | $V_H$ | $(V_L + V_H)/2$ |

As can be seen, the output SDSPA of the differential switching power amplifier is $(V_L+V_H)/2$ when both pulse width modulated signals SPWM1 and SPWM2 are either voltage-low $V_L$ or voltage-high $V_H$, i.e. both switching transistors T1 and T2 of the differential switching power amplifier are switched on or off, respectively. Most of the power dissipation of the differential switching power amplifier is caused by the on-resistance of the switching transistors T1 and T2. Thus, switching on both switching transistors T1 and T2, which corresponds to state 4 in the upper table, to produce a voltage $(V_L+V_H)/2$ at the differential switching power amplifier output results in a high power dissipation and should be avoided.

In an embodiment according to the invention, a so-called H-Bridge is employed as amplifier stage in order to circumvent the problem of the high power dissipation.

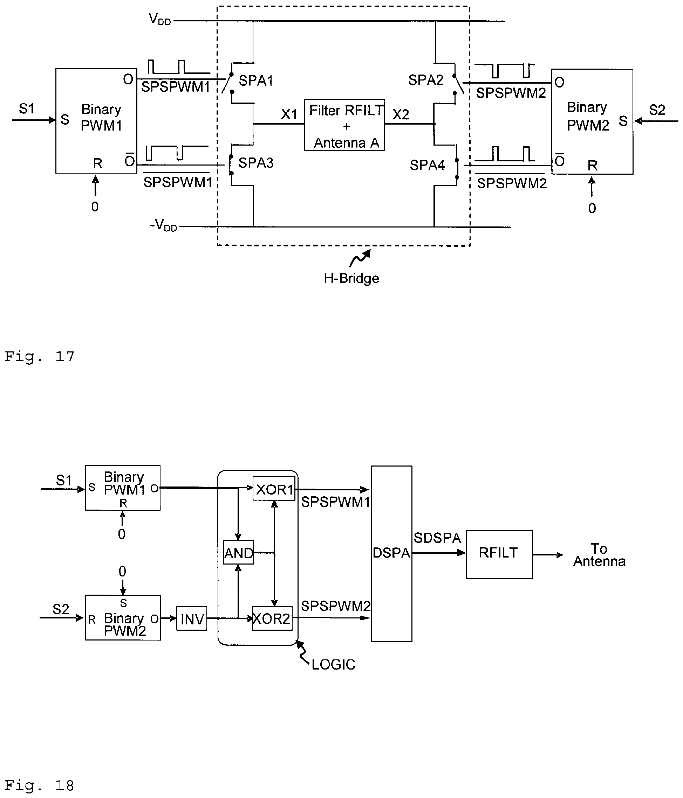

Fig. 17 schematically shows exemplarily a transmitter for amplification of distributed 3-level pulse width modulated signals using two pulse width modulators, and a H-Bridge power amplifier according to an embodiment of the invention.

The transmitter comprises a first and a second pulse width modulator PWM1, PWM2, and a H-bridge power amplifier. The H-bridge power amplifier in turn comprises four switching power amplifiers SPA1-SPA4, and a processing unit with a reconstruction filter RFILT, and an antenna A.

A first output O of the first pulse width modulator PWM1 is connected to the first switching power amplifier SPA1, and a second output $\overline{O}$ of the first pulse width modulator PWM1 is connected to the third switching power amplifier SPA3.

The first and the third switching power amplifier SPA1 and SPA3 are connected to a first input of the processing unit with the reconstruction filter RFILT, and the antenna A.

A drain of the first switching power amplifier SPA1 is connected to a positive power supply $V_{DD}$, and a source of the third switching power amplifier SPA3 is connected to a negative power supply $-V_{DD}$.

A first output O of the second pulse width modulator PWM2 is connected to the second switching power amplifier SPA2, and a second output $\overline{O}$ of the second pulse width modulator PWM2 is connected to the fourth switching power amplifier SPA4.

The second and the fourth switching power amplifier SPA2 and SPA4 are connected to a second input of the processing unit with the reconstruction filter RFILT, and the antenna A.

A drain of the second switching power amplifier SPA2 is connected to the positive power supply $V_{DD}$, and a source of the fourth switching power amplifier SPA4 is connected to the negative power supply $-V_{DD}$.

A first upconverted signal S1 is transmitted to a signal input of the first pulse width modulator PWM1, and a reference signal at constant level 0 is fed to a reference input of the first pulse width modulator PWM1. As described above under fig. 8, a first phase shifted pulse width modulated signal SPSPWM1 results from a comparison of the first upconverted signal S1 with the reference signal at constant level 0, and said first phase shifted pulse width modulated signal SPSPWM1 is sent via the first output O to the first switching power amplifier SPA1.

Also, an inverted first phase shifted pulse width modulated signal $\overline{SPSPWM1}$ is sent via the second output $\overline{O}$ of the first pulse width modulator PWM1 to the third switching power amplifier SPA3.

A second upconverted signal S2 is transmitted to a signal input of the second pulse width modulator PWM2, and the reference signal at constant level 0 is fed to a reference signal input of the second pulse width modulator PWM2. As described above under fig. 8, a second phase shifted pulse width modulated signal SPSPWM2 results from a comparison of the second upconverted signal S2 with the reference signal at constant level 0, and said second phase shifted pulse width modulated signal SPSPWM2 is sent via the first output O to the second switching power amplifier SPA2. Also, an inverted second phase shifted pulse width modulated signal $\overline{SPSPWM2}$ is sent via the second output $\overline{O}$ of the second pulse width modulator PWM2 to the fourth switching power amplifier SPA4.

The amplification of the first and second phase shifted pulse width modulated signals SPSPWM1, SPSPWM2, and the inverted first and second phase shifted pulse width modulated signal $\overline{SPSPWM1}$, $\overline{SPSPWM2}$ results in a ternary signal e.g. as depicted in fig. 8.

The H-bridge power amplifier yields a differential ternary signal, as e.g. depicted in fig. 8, between the points X1 and X2 in fig. 17, which is an amplified version of the difference between the first and second phase shifted pulse width modulated signals SPSPWM1, SPSPWM2. Let denote the difference between X1 and X2 as SX. This differential ternary signal is delivered to the differential input of a processing unit with a reconstruction filter RFILT and antenna A.

Let denote the voltage-high and voltage-low of the first binary phase shifted pulse width modulated signal SPSPWM1 by $V_h$ and $V_l$, respectively. Equivalently, the voltage-high and voltage-low of the second binary phase shifted pulse width modulated signal SPSPWM2 by $V_h$ and $V_l$, respectively. If SPSPWM1 and SPSPWM2 equals $V_h$, then the differential signal SX between X1 and X2 equals zero. Similarly, if SPSPWM1 and SPSPWM2

equals $V_l$, then SX equals zero. If SPSPWM1 equals $V_h$ and SPSPWM2 equals $V_l$, then SX equals a positive value $V_X$. If SPSPWM1 equals $V_L$ and SPSPWM2 equals $V_H$, then SX equals $-V_X$.

In conventional state-of-the-art differential switching power amplifiers the output would be undefined, if SPSPWM1 and SPSPWM2 equal $V_L$. The H-bridge power amplifier circumvents inherently this problem.

The ternary signal is then filtered in a reconstruction filter RFILT preferably of low pass or band pass type for converting the ternary signal into an analogue signal.

The H-Bridge architecture appears to be an ideally suited amplifier for distributed ternary pulse width modulated signals, i.e. for two binary pulse width modulated signal streams. The H-Bridge avoids that the two switching power amplifiers SPA1 and SPA3 are switched on at the same time, and the H-Bridge also avoids that the two switching power amplifiers SPA2 and SPA4 are switched on at the same time, as the respective switching power amplifiers are connected to the pairs of differential output ports of the two binary pulse width modulators PWM1 and PWM2.

According to a further embodiment of the invention, the problem of the high power dissipation described above is circumvented by prepending a logic circuit at the input of the differential switching power amplifier, which maps the state 4 to the state 1 in the upper table, i.e. instead of switching both switching transistors T1 and T2 in fig. 15 or 16 on, both transistors are switched off.

Fig. 18 schematically shows exemplarily a transmitter for amplification of distributed 3-level pulse width modulated signals using two pulse width modulators, an inverter, a logic circuit, and a differential switching power amplifier according to an embodiment of the invention.

As the embodiment in fig. 18 in principle corresponds to the embodiment depicted in fig. 13, only the differences are described in the following.

A logical circuit LOGIC comprising a first and a second element for performing an exclusive-or-operation XOR1 and XOR2, and an element for performing an and-operation AND is inserted between the first and the second pulse width modulators PWM1, PWM2, and the differential switching power amplifier DSPA.

The output of the first pulse width modulator PWM1 is connected both to a first input of the first element for performing an exclusive-or-operation XOR1, and to a first input of the element for performing an and-operation AND.

The output of the second pulse width modulator PWM2 is connected via the inverter INV both to a first input of the second element for performing an exclusive-or-operation XOR2, and to a second input of the element for performing an and-operation AND.

An output of the element for performing an and-operation AND is connected both to a second input of the first element for performing an exclusive-or-operation XOR1, and to a second input of the second element for performing an exclusive-or-operation XOR2.

An output of the first element for performing an exclusive-or-operation XOR1 is connected to the first input of the differential switching power amplifier DSPA, and an output of the second element for performing an exclusive-or-operation XOR2 is connected to the second input of the differential switching power amplifier DSPA.

If both input values to the logical circuit LOGIC are voltage-high $V_H$, the output value of the element for performing an and-operation AND is also voltage-high $V_H$. Thus, both input values of both elements for performing an exclusive-or-operation XOR1 and XOR2 are voltage-high $V_H$, which leads to both output values SPWM1 and SPWM2 of the logical circuit LOGIC being voltage-low $V_L$.

Thus, said logical circuit LOGIC maps the state 4 to the state 1 in the upper table, i.e. instead of switching both switching transistors T1 and T2 in fig. 15 or 16 on, both transistors are switched off.

In the embodiments described above, out of an input signal on baseband level SBB, a distributed ternary pulse width modulated signal SPWM is generated which is composed out of two binary pulse width modulated signals. However, generally an input signal can also be converted into an arbitrary distributed multi-level signal which is composed out of multiple binary pulse width modulated signals by means of using multiple pulse width modulators with different comparator thresholds, amplifying the multiple binary pulse width modulated signals, and adding the amplified multiple binary pulse width modulated signals.

As an example for an application of a transmitter according to the invention, a base station in a wireless communication network can comprise a transmitter according to one of the embodiments described above, and an antenna network for transmission of signals over an air interface.

**Claims**

1. A method for pulse width modulation of an input signal (SBB) using at least one pulse width modulator (PWM1, PWM2, PWM), wherein

   • a reference signal at constant level 0 is fed to an input of said at least one pulse width modulator,
   • the input signal (SBB) is upconverted on a carrier frequency, phase shifted and pulse width modulated in said at least one pulse width modulator (PWM1, PWM2, PWM) by comparing the upconverted signal with the reference signal resulting in a first and a second phase shifted pulse width modulated signal with two levels (SPSPWM1, SPSPWM2),

   • said first and second phase shifted pulse width modulated signal with two levels (SPSPWM1, SPSPWM2) have a phase difference ($2\Delta$) which is dependent on the amplitude of the input signal (SBB),
   • and a superposition of said first and second phase shifted pulse width modulated signal with two levels (SPSPWM1, SPSPWM2) is performed resulting in a signal with three levels (SPWM, SSPA, SDSPA).

2. A method according to claim 1, wherein

   • a first and a second phase ($\psi 1, \psi 2$) are determined based on a phase ($\Phi$) of the input signal (SBB) and having said phase difference ($2\Delta$) which is dependent on the amplitude of the input signal (SBB),
   • a first upconverted signal (S1) on the carrier frequency is generated using said first phase ($\psi 1$),
   • a second upconverted signal (S2) on the carrier frequency is generated using said second phase ($\psi 2$),
   • the first upconverted signal (S1) is pulse width modulated in a first of said at least one pulse width modulator (PWM1), and the second upconverted signal (S2) is pulse width modulated in a second of said at least one pulse width modulator (PWM2) resulting in said first and second phase shifted pulse width modulated signal with two levels (SPSPWM1, SPSPWM2).

3. A method according to claim 2, wherein the second upconverted signal (S2) is fed to an input for a reference signal, and the reference signal is fed to an input for a data signal in the second of said at least one pulse width modulator (PWM2).

4. A method according to claim 1, wherein

   • a first and a second phase difference ($-\Delta,+\Delta$) are determined dependent on the amplitude of the input signal (SBB),
   • an upconverted signal (S3) on the carrier frequency is generated using as phase a phase ($\Phi$) of the input signal (SBB),
   • the upconverted signal (S3) is pulse width modulated in said at least one pulse width modulator (PWM) resulting in a first pulse width modulated signal with two levels (SPWM1), and in a second pulse width modulated signal with two levels (SPWM2) corresponding to the inverted first pulse width modulated signal with two levels (SPWM1),
   • the first pulse width modulated signal with two levels (SPWM1) is phase-shifted by the first phase difference ($-\Delta$) resulting in said first phase shifted pulse width modulated signal with two levels (SPSPWM1),

• and the second pulse width modulated signal with two levels (SPWM2) is phase-shifted by the second phase difference ($\Delta$) resulting in said second phase shifted pulse width modulated signal with two levels (SPSPWM2).

5. A method according to claim 1, wherein

• a first and a second phase difference ($-2\Delta,+\Delta$) are determined dependent on the amplitude of the input signal (SBB),
• an upconverted signal (S4) on the carrier frequency is generated using as phase a phase ($\Phi$) of the input signal (SBB) and said second phase difference ($+\Delta$),
• the upconverted signal (S4) is pulse width modulated in said at least one pulse width modulator (PWM) resulting in a first pulse width modulated signal with two levels (SPWM1), and in a second pulse width modulated signal with two levels (SPWM2) corresponding to the inverted first pulse width modulated signal with two levels (SPWM1),
• the first pulse width modulated signal with two levels (SPWM1) is phase-shifted by the first phase difference ($-2\Delta$) resulting in said first phase shifted pulse width modulated signal with two levels (SPSPWM1),
• and the second pulse width modulated signal with two levels (SPWM2) is phase-shifted by a fix phase difference resulting in said second phase shifted pulse width modulated signal with two levels (SPSPWM2).

6. A method according to any of the preceeding claims, wherein

• said first and second phase shifted pulse width modulated signal with two levels (SPSPWM1, SPSPWM2) are first amplified in at least one switching power amplifier (SPA1, SPA2, DSPA) before said superposition of said first and second phase shifted pulse width modulated signal with two levels (SPSPWM1, SPSPWM2) results in said signal with three levels (SSPA, SDSPA),
• and said signal with three levels (SSPA, SDSPA) is converted to an analogue signal.

7. A method according to claim 3, wherein

• said first and second phase shifted pulse width modulated signal with two levels (SPSPWM1, SPSPWM2) are first amplified in a differential switching power amplifier (DSPA) before said superposition of said first and second phase shifted pulse width modulated signal with two levels (SPSPWM1, SPSPWM2) results in said signal with three levels (SDSPA),
• one of said first and second phase shifted pulse width modulated signal with two levels (SPSPWM1, SPSPWM2) is inverted before amplification in said differential switching power amplifier (DSPA),
• and said signal with three levels (SDSPA) is converted to an analogue signal.

8. A method according to claim 2, wherein

• the first phase shifted pulse width modulated signal with two levels (SPSPWM1), and an inverted first phase shifted pulse width modulated signal with two levels (**SPSPWM1**) are generated in the first of said at least one pulse width modulator (PWM1),
• the second phase shifted pulse width modulated signal with two levels (SPSPWM2), and an inverted second phase shifted pulse width modulated signal with two levels (**SPSPWM2**) are generated in the second of said at least one pulse width modulator (PWM2),
• and the first phase shifted pulse width modulated signal with two levels (SPSPWM1), the inverted first phase shifted pulse width modulated signal with two levels ($\overline{SPSPWM1}$), the second phase shifted pulse width modulated signal with two levels (SPSPWM2), and the inverted second phase shifted pulse width modulated signal with two levels ($\overline{SPSPWM2}$) are combined and amplified differentially using an H-bridge power amplifier.

9. A method according to claim 7 wherein a state in which both switching transistors of the differential switching power amplifier (DSPA) are switched on is changed to a state in which both switching transistors of the differential switching power amplifier (DSPA) are switched off by means of a logic circuit (LOGIC).

10. A transmitter comprising at least one pulse width modulator (PWM1, PWM2) for pulse width modulation of an input signal (SBB), wherein

• said transmitter is adapted to upconvert the input signal (SBB) on a carrier frequency, to phase shift the input signal (SBB), and to pulse width modulate the input signal (SBB) in said at least one pulse width modulator (PWM1, PWM2, PWM) by comparing the upconverted signal with a reference signal at constant level 0 which is fed to an input of said at least one pulse width modulator resulting in a first and a second phase shifted pulse width modulated signal with two levels (SPSPWM1, SPSPWM2),

• said first and second phase shifted pulse width modulated signal with two levels (SPSPWM1, SPSPWM2) have a phase difference (2Δ) which is dependent on the amplitude of the input signal (SBB),

• and said transmitter is adapted to perform a superposition of said first and second phase shifted pulse width modulated signal with two levels (SPSPWM1, SPSPWM2) which results in a signal with three levels (SPWM, SSPA, SDSPA) .

11. A transmitter according to claim 10, comprising at least one switching power amplifier (SPA1, SPA2, DSPA) for signal amplification, and a converting device for digital-to-analogue conversion (RFILT), wherein

• said at least one switching power amplifier (SPA1, SPA2, DSPA) is adapted to amplify said first and second phase shifted pulse width modulated signal with two levels (SPSPWM1, SPSPWM2) before said superposition of said first and second phase shifted pulse width modulated signal with two levels (SPSPWM1, SPSPWM2) results in said signal with at least three levels (SSPA, SDSPA),

• and said converting device for digital-to-analogue conversion (RFILT) is adapted to convert said signal with at least three levels (SSPA, SDSPA) to an analogue signal.

12. A base station comprising a transmitter according to claim 11 and at least one antenna network for transmission of signals over an air interface.

**Patentansprüche**

1. Verfahren zur Pulsweitenmodulation eines Eingangssignals (SBB) unter Verwendung mindestens eines Pulsweitenmodulators (PWM1, PWM2, PWM), wobei

• ein Referenzsignal auf konstanter Stufe 0 einem Eingang des besagten mindestens einen Pulsweitenmodulators zugeführt wird,

• das Eingangssignal (SBB) in dem besagten mindestens einen Pulsweitenmodulator (PWM1, PWM2, PWM) auf eine Trägerfrequenz aufwärtskonvertiert, phasenverschoben und pulsweitenmoduliert wird durch Vergleichen des aufwärtskonvertierten Signals mit dem Referenzsignal, was zu einem ersten und einem zweiten phasenverschobenen pulsweitenmodulierten Signal mit zwei Stufen (SPSPWM1, SPSPWM2) führt,

• das besagte erste und zweite phasenverschobene pulsweitenmodulierte Signal mit zwei Stufen (SPSPWM1, SPSPWM2) eine Phasendifferenz (2Δ) aufweisen, die von der Amplitude des Eingangssignals (SBB) abhängig ist,

• und eine Überlagerung des besagten ersten und zweiten phasenverschobenen pulsweitenmodulierten Signals mit zwei Stufen (SPSPWM1, SPSPWM2) durchgeführt wird, was zu einem Signal mit drei Stufen (SPWM, SSPA, SDSPA) führt.

2. Verfahren nach Anspruch 1, wobei

• eine erste und eine zweite Phase (φ1, φ2) bestimmt werden basierend auf einer Phase (Φ) des Eingangssignals (SBB) und die besagte Phasendifferenz (2Δ) aufweisend, die von der Amplitude des Eingangssignals (SBB) abhängig ist,

• ein erstes auf die Trägerfrequenz aufwärtskonvertiertes Signal (S1) unter Verwendung der besagten ersten Phase (φ1) erzeugt wird,

• ein zweites auf die Trägerfrequenz aufwärtskonvertiertes Signal (S2) unter Verwendung der besagten zweiten Phase (φ2) erzeugt wird,

• das erste aufwärtskonvertierte Signal (S1) in einem ersten des besagten mindestens einen Pulsweitenmodulators (PWM1) pulsweitenmoduliert wird, und das zweite aufwärtskonvertierte Signal (S2) in einem zweiten des besagten mindestens einen Pulsweitenmodulators (PWM2) pulsweitenmoduliert wird, was zu dem besagten ersten und zweiten phasenverschobenen pulsweitenmodulierten Signal mit zwei Stufen (SPSPWM1, SPSPWM2) führt.

3. Verfahren nach Anspruch 2, wobei das zweite aufwärtskonvertierte Signal (S2) einem Eingang für ein Referenzsignal zugeführt wird, und das Referenzsignal einem Eingang für ein Datensignal in dem zweiten des besagten mindestens einen Pulsweitenmodulators (PWM2) zugeführt wird.

4. Verfahren nach Anspruch 1, wobei

• eine erste und eine zweite Phasendifferenz (-Δ, +Δ) bestimmt werden in Abhängigkeit von der Amplitude des Eingangssignals (SBB),

• ein auf die Trägerfrequenz aufwärtskonvertiertes Signal (S3) unter Verwendung einer Phase (Φ) des Eingangssignals (SBB) als Phase erzeugt wird,

• das aufwärtskonvertierte Signal (S3) in dem besagten mindestens einen Pulsweitenmodulator (PWM) pulsweitenmoduliert wird, was zu einem ersten pulsweitenmodulierten Signal mit zwei Stufen (SPWM1) und zu einem zweiten pulsweitenmodulierten Signal mit zwei Stufen (SPWM2) führt, das dem umgekehrten ersten pulsweitenmodulierten Signal mit zwei Stufen (SPWM1) entspricht,

• das erste pulsweitenmodulierte Signal mit zwei Stufen (SPWM1) um die erste Phasendifferenz (-Δ) phasenverschoben wird, was zu dem besagten ersten phasenverschobenen pulsweitenmodulierten Signal mit zwei Stufen (SPSPWM1) führt,

• und das zweite pulsweitenmodulierte Signal mit zwei Stufen (SPWM2) um die zweite Phasendifferenz (Δ) phasenverschoben wird, was zu dem besagten zweiten phasenverschobenen pulsweitenmodulierten Signal mit zwei Stufen (SPSPWM2) führt.

5. Verfahren nach Anspruch 1, wobei

• eine erste und eine zweite Phasendifferenz (-2Δ, +Δ) bestimmt werden in Abhängigkeit von der Amplitude des Eingangssignals (SBB),

• ein auf die Trägerfrequenz aufwärtskonvertiertes Signal (S4) unter Verwendung einer Phase (Φ) des Eingangssignals (SBB) als Phase und der besagten zweiten Phasendifferenz (+Δ) erzeugt wird,

• das aufwärtskonvertierte Signal (S4) in dem besagten mindestens einen Pulsweitenmodulator (PWM) pulsweitenmoduliert wird, was zu einem ersten pulsweitenmodulierten Signal mit zwei Stufen (SPWM1) und zu einem zweiten pulsweitenmodulierten Signal mit zwei Stufen (SPWM2) führt, das dem umgekehrten ersten pulsweitenmodulierten Signal mit zwei Stufen (SPWM1) entspricht,

• das erste pulsweitenmodulierte Signal mit zwei Stufen (SPWM1) um die erste Phasendifferenz (-2Δ) phasenverschoben wird, was zu dem besagten ersten phasenverschobenen pulsweitenmodulierten Signal mit zwei Stufen (SPSPWM1) führt,

• und das zweite pulsweitenmodulierte Signal mit zwei Stufen (SPWM2) um eine feste Phasendifferenz phasenverschoben wird, was zu dem besagten zweiten phasenverschobenen pulsweitenmodulierten Signal mit zwei Stufen (SPSPWM2) führt.

6. Verfahren nach einem beliebigen der vorstehenden Ansprüche, wobei

• das besagte erste und zweite phasenverschobene pulsweitenmodulierte Signal mit zwei Stufen (SPSPWM1, SPSPWM2) zuerst in mindestens einem Schaltleistungsverstärker (SPA1, SPA2, DSPA) verstärkt werden, bevor die besagte Überlagerung des besagten ersten und zweiten phasenverschobenen pulsweitenmodulierten Signals mit zwei Stufen (SPSPWM1, SPSPWM2) zu dem besagten Signal mit drei Stufen (SSPA, SDSPA) führt,

• und das besagte Signal mit drei Stufen (SSPA, SDSPA) in ein analoges Signal konvertiert wird.

7. Verfahren nach Anspruch 3, wobei

• das besagte erste und zweite phasenverschobene pulsweitenmodulierte Signal mit zwei Stufen (SPSPWM1, SPSPWM2) zuerst in einem differentiellen Schaltleistungsverstärker (DSPA) verstärkt werden, bevor die besagte Überlagerung des besagten ersten und zweiten phasenverschobenen pulsweitenmodulierten Signals mit zwei Stufen (SPSPWM1, SPSPWM2) zu dem besagten Signal mit drei Stufen (SDSPA) führt,

• eines des besagten ersten und zweiten phasenverschobenen pulsweitenmodulierten Signals mit zwei Stufen (SPSPWM1, SPSPWM2) vor der Verstärkung in dem besagten differentiellen Schaltleistungsverstärker (DSPA) umgekehrt wird,

• und das besagte Signal mit drei Stufen (SDSPA) in ein analoges Signal konvertiert wird.

8. Verfahren nach Anspruch 2, wobei

• das erste phasenverschobene pulsweitenmodulierte Signal mit zwei Stufen (SPSPWM1) und ein umgekehrtes erstes phasenverschobenes pulsweitenmoduliertes Signal mit zwei Stufen (SPSPWM1) in dem ersten des besagten mindestens einen Pulsweitenmodulators (PWM1) erzeugt werden,

• das zweite phasenverschobene pulsweitenmodulierte Signal mit zwei Stufen (SPSPWM2) und ein umgekehrtes zweites phasenverschobenes pulsweitenmoduliertes Signal mit zwei Stufen (SPSPWM2) in dem zweiten des besagten mindestens einen Pulsweitenmodulators (PWM2) erzeugt werden,

• und das erste phasenverschobene pulsweitenmodulierte Signal mit zwei Stufen (SPSPWM1), das umgekehrte erste phasenverschobene pulsweitenmodulierte Signal mit zwei Stufen (SPSPWM1), das zweite phasenverschobene pulsweitenmodulierte Signal mit zwei Stufen (SPSPWM2) und das umgekehrte zweite phasenverschobene pulsweitenmodulierte Signal mit zwei Stufen (SPSPWM2) kombiniert und differentiell verstärkt werden unter Verwendung eines H-Brücke-Leistungsverstärkers.

9. Verfahren nach Anspruch 7, wobei ein Zustand, in dem beide Schalttransistoren des differentiellen Schaltleistungsverstärkers (DSPA) eingeschaltet sind, geändert wird in einen Zustand, in dem beide Schalttransistoren des differentiellen Schaltleistungsverstärkers (DSPA) ausgeschaltet sind, mittels einer Logikschaltung (LOGIC).

10. Sender, der mindestens einen Pulsweitenmodulator (PWM1, PWM2) zur Pulsweitenmodulation eines Eingangssignals (SBB) umfasst, wobei

  • der besagte Sender angepasst ist zum Aufwärtskonvertieren des Eingangssignals (SBB) auf eine Trägerfrequenz, zum Phasenverschieben des Eingangssignals (SBB) und zum Pulsweitenmodulieren des Eingangssignals (SBB) in dem besagten mindestens einen Pulsweitenmodulator (PWM1, PWM2, PWM) durch Vergleichen des aufwärtskonvertierten Signals mit einem Referenzsignal auf konstanter Stufe 0, das einem Eingang des besagten mindestens einen Pulsweitenmodulators zugeführt wird, was zu einem ersten und einem zweiten phasenverschobenen pulsweitenmodulierten Signal mit zwei Stufen (SPSPWM1, SPSPWM2) führt,
  • das besagte erste und zweite phasenverschobene pulsweitenmodulierte Signal mit zwei Stufen (SPSPWM1, SPSPWM2) eine Phasendifferenz ($2\Delta$) aufweisen, die von der Amplitude des Eingangssignals (SBB) abhängig ist,
  • und der besagte Sender angepasst ist zum Durchführen einer Überlagerung des besagten ersten und zweiten phasenverschobenen pulsweitenmodulierten Signals mit zwei Stufen (SPSPWM1, SPSPWM2), was zu einem Signal mit drei Stufen (SPWM, SSPA, SDSPA) führt.

11. Sender nach Anspruch 10, umfassend mindestens einen Schaltleistungsverstärker (SPA1, SPA2, DSPA) zur Signalverstärkung und eine Umsetzungsvorrichtung zur Digital-Analog-Umsetzung (RFILT), wobei

  • der besagte mindestens eine Schaltleistungsverstärker (SPA1, SPA2, DSPA) angepasst ist zum Verstärken des besagten ersten und zweiten phasenverschobenen pulsweitenmodulierten Signals mit zwei Stufen (SPSPWM1, SPSPWM2), bevor die besagte Überlagerung des besagten ersten und zweiten phasenverschobenen pulsweitenmodulierten Signals mit zwei Stufen (SPSPWM1, SPSPWM2) zu dem besagten Signal mit mindestens drei Stufen (SSPA, SDSPA) führt,
  • und die besagte Umsetzungsvorrichtung zur Digital-Analog-Umsetzung (RFILT) angepasst ist zum Konvertieren des besagten Signals mit mindestens drei Stufen (SSPA, SDSPA) in ein analoges Signal.

12. Basisstation, umfassend einen Sender nach Anspruch 11 und mindestens ein Antennennetzwerk zur Übertragung von Signalen über eine Luftschnittstelle.

## Revendications

1. Procédé de modulation de largeur d'impulsion d'un signal d'entrée (SBB) en utilisant au moins un modulateur de largeur d'impulsion (PWM1, PWM2), dans lequel

  • un signal de référence à un niveau constant 0 est délivré à une entrée dudit au moins un modulateur de largeur d'impulsion,
  • le signal d'entrée (SBB) subit une conversion ascendante sur une fréquence porteuse, est déphasé et est modulé en largeur d'impulsion dans ledit au moins un modulateur de largeur d'impulsion (PWM1, PWM2, PWM) en comparant le signal ayant subi une conversion ascendante au signal de référence ayant pour résultat un premier et un second signaux déphasés et modulés en largeur d'impulsion à deux niveaux (SPSPWM1, SPSPWM2),
  • lesdits premier et second signaux déphasés et modulés en largeur d'impulsion à deux niveaux (SPSPWM1, SPSPWM2) ont une différence de phase ($2\Delta$) qui dépend de l'amplitude du signal d'entrée (SBB),
  • et une superposition desdits premier et second signaux déphasés et modulés en largeur d'impulsion à deux niveaux (SPSPWM1, SPSPWM2) est effectuée ayant pour résultat un signal à trois niveaux (SPWM, SSPA, SDSPA).

2. Procédé selon la revendication 1, dans lequel

  • une première et une seconde phases ($\Phi_1$, $\Phi_2$) sont déterminées sur la base d'une phase ($\Phi$) du signal d'entrée (SBB) et ayant ladite différence de phase ($2\Delta$) qui dépend de l'amplitude du signal d'entrée (SBB),
  • un premier signal ayant subi une conversion ascendante (S1) sur la fréquence porteuse est généré en utilisant ladite première phase ($\Phi_1$),
  • un second signal ayant subi une conversion ascendante (S2) sur la fréquence porteuse est généré en utilisant ladite seconde phase ($\Phi_2$),
  • le premier signal ayant subi une conversion ascendante (S1) est modulé en largeur d'impulsion dans un premier modulateur parmi ledit au moins un modulateur de largeur d'impulsion (PWM1), et le second signal ayant subi une conversion ascendante (S2) est modulé en largeur d'impulsion dans un second modulateur parmi ledit au moins un modulateur de largeur d'impulsion (PWM2) ayant pour résultat lesdits premier et second signaux déphasés et modulés en largeur d'impulsion à deux niveaux (SPSPWM1, SPSPWM2).

**3.** Procédé selon la revendication 2, dans lequel le second signal ayant subi une conversion ascendante (S2) est délivré à une entrée en tant que signal de référence, et le signal de référence est délivré à une entrée en tant que signal de données dans le second modulateur parmi ledit au moins un modulateur de largeur d'impulsion (PWM2).

**4.** Procédé selon la revendication 1, dans lequel

• une première et une seconde différences de phase (-Δ,+Δ) sont déterminées en fonction de l'amplitude du signal d'entrée (SBB),
• un signal ayant subi une conversion ascendante (S3) sur la fréquence porteuse est généré en utilisant en tant que phase une phase (Φ) du signal d'entrée (SBB),
• le signal ayant subi une conversion ascendante (S3) est modulé en largeur d'impulsion dans ledit au moins un modulateur de largeur d'impulsion (PWM), ayant pour résultat un premier signal modulé en largeur d'impulsion à deux niveaux (SPWM1), et un second signal modulé en largeur d'impulsion à deux niveaux (SPWM2) correspondant au premier signal modulé en largeur d'impulsion à deux niveaux (SPWM1) inversé,
• le premier signal modulé en largeur d'impulsion à deux niveaux (SPWM1) est déphasé par la première différence de phase (-Δ) ayant pour résultat ledit premier signal déphasé et modulé en largeur d'impulsion à deux niveaux (SPSPWM1),
• et le second signal modulé en largeur d'impulsion à deux niveaux (SPWM2) est déphasé par la seconde différence de phase (Δ) ayant pour résultat ledit second signal déphasé et modulé en largeur d'impulsion à deux niveaux (SPSPWM2).

**5.** Procédé selon la revendication 1, dans lequel

• une première et une seconde différences de phase (-2Δ, +Δ) sont déterminées en fonction de l'amplitude du signal d'entrée (SBB),
• un signal ayant subi une conversion ascendante (S4) sur la fréquence porteuse est généré en utilisant en tant que phase une phase (Φ) du signal d'entrée (SBB) et ladite seconde différence de phase (+Δ),
• le signal ayant subi une conversion ascendante (S4) est modulé en largeur d'impulsion dans ledit au moins un modulateur de largeur d'impulsion (PWM), ayant pour résultat un premier signal modulé en largeur d'impulsion à deux niveaux (SPWM1), et un second signal modulé en largeur d'impulsion à deux niveaux (SPWM2) correspondant au premier signal modulé en largeur d'impulsion à deux niveaux (SPWM1) inversé,
• le premier signal modulé en largeur d'impulsion à deux niveaux (SPWM1) est déphasé par la première différence de phase (-2Δ) ayant pour résultat ledit premier signal déphasé et modulé en largeur d'impulsion à deux niveaux (SPSPWM1),
• et le second signal modulé en largeur d'impulsion à deux niveaux (SPWM2) est déphasé par une différence de phase fixe ayant pour résultat ledit second signal déphasé et modulé en largeur d'impulsion à deux niveaux (SPSPWM2).

**6.** Procédé selon l'une quelconque des revendications précédentes, dans lequel

• lesdits premier et second signaux déphasés et modulés en largeur d'impulsion à deux niveaux (SPSPWM1, SPSPWM2) sont d'abord amplifiés dans au moins un amplificateur de puissance à commutation (SPA1, SPA2, DSPA) avant que ladite superposition desdits premier et second signaux déphasés et modulés en largeur d'impulsion à deux niveaux (SPSPWM1, SPSPWM2) ait pour résultat ledit signal à trois niveaux (SSPA, SDSPA),
• et ledit signal à trois niveaux (SSPA, SDSPA) est converti en un signal analogique.

**7.** Procédé selon la revendication 3, dans lequel

• lesdits premier et second signaux déphasés et modulés en largeur d'impulsion à deux niveaux (SPSPWM1, SPSPWM2) sont d'abord amplifiés dans un amplificateur de puissance à commutation différentiel (DSPA) avant que ladite superposition desdits premier et second signaux déphasés et modulés en largeur d'impulsion à deux niveaux (SPSPWM1, SPSPWM2) ait pour résultat ledit signal à trois niveaux (SDSPA),
• un desdits premier et second signaux déphasés et modulés en largeur d'impulsion à deux niveaux (SPSPWM1, SPSPWM2) est inversé avant l'amplification dans ledit amplificateur de puissance à commutation différentiel (DSPA),
• et ledit signal à trois niveaux (SDSPA) est converti en un signal analogique.

**8.** Procédé selon la revendication 2, dans lequel

• le premier signal déphasé et modulé en largeur d'impulsion à deux niveaux (SPSPWM1), et un premier signal déphasé et modulé en largeur d'impulsion à deux niveaux (SPSPWM1) inversé sont générés dans le premier modulateur parmi ledit au moins un modulateur de largeur d'impulsion (PWM1),

• le second signal déphasé et modulé en largeur d'impulsion à deux niveaux (SPSPWM2), et un second signal déphasé et modulé en largeur d'impulsion à deux niveaux (SPSPWM2) inversé sont générés dans le second modulateur parmi ledit au moins un modulateur de largeur d'impulsion (PWM2),

• et le premier signal déphasé et modulé en largeur d'impulsion à deux niveaux (SPSPWM1), le premier signal déphasé et modulé en largeur d'impulsion à deux niveaux (SPSPWM1) inversé, le second signal déphasé et modulé en largeur d'impulsion à deux niveaux (SPSPWM2) et le second signal déphasé et modulé en largeur d'impulsion à deux niveaux (SPSPWM2) inversé sont combinés et amplifiés de manière différentielle en utilisant un amplificateur de puissance à pont en H.

9. Procédé selon la revendication 7, dans lequel un état, dans lequel les deux transistors de commutation de l'amplificateur de puissance à commutation différentiel (DSPA) sont activés, change pour un état dans lequel les deux transistors de commutation de l'amplificateur de puissance à commutation différentiel (DSPA) sont désactivés au moyen d'un circuit logique (LOGIC).

10. Émetteur comprenant au moins un modulateur de largeur d'impulsion (PWM1, PWM2) pour la modulation de largeur d'impulsion d'un signal d'entrée (SBB), dans lequel

   • ledit émetteur est adapté pour convertir de façon ascendante le signal d'entrée (SBB) sur une fréquence porteuse, pour déphaser le signal d'entrée (SBB), et pour moduler en largeur d'impulsion le signal d'entrée (SBB) dans ledit au moins un modulateur de largeur d'impulsion (PWM1, PWM2, PWM) en comparant le signal ayant subi une conversion ascendante à un signal de référence à niveau constant 0 qui est délivré à une entrée dudit au moins un modulateur de largeur d'impulsion ayant pour résultat un premier et un second signaux déphasés et modulés en largeur d'impulsion à deux niveaux (SPSPWM1, SPSPWM2),

   • lesdits premier et second signaux déphasés et modulés en largeur d'impulsion à deux niveaux (SPSPWM1, SPSPWM2) ont une différence de phase (2Δ) qui dépend de l'amplitude du signal d'entrée (SBB),

   • et ledit émetteur est adapté pour effectuer une superposition desdits premier et second signaux déphasés et modulés en largeur d'impulsion à deux niveaux (SPSPWM1, SPSPWM2) ayant pour résultat un signal à trois niveaux (SPWM, SSPA, SDSPA).

11. Émetteur selon la revendication 10, comprenant au moins un amplificateur de puissance à commutation (SPA1, SPA2, DSPA) pour l'amplification de signaux, et un dispositif de conversion pour la conversion numérique/analogique (RFILT), dans lequel

   • ledit au moins un amplificateur de puissance à commutation (SPA1, SPA2, DSPA) est adapté pour amplifier lesdits premier et second signaux déphasés et modulés en largeur d'impulsion à deux niveaux (SPSPWM1, SPSPWM2) avant que ladite superposition desdits premier et second signaux déphasés et modulés en largeur d'impulsion à deux niveaux (SPSPWM1, SPSPWM2) ait pour résultat ledit signal à au moins trois niveaux (SSPA, SDSPA),

   • et ledit dispositif de conversion pour la conversion numérique/analogique (RFILT) est adapté pour convertir ledit signal à au moins trois niveaux (SSPA, SDSPA) en un signal analogique.

12. Station de base comprenant un émetteur selon la revendication 11 et au moins un réseau d'antennes pour la transmission de signaux sur une interface radio.

Fig. 1

Fig. 2

Fig. 3

Fig. 4

Fig. 5

Fig. 6

$S1=a*\sin(2\pi f_c t+\Phi(SBB(t))-\Delta(SBB(t)))$

SPSPWM1

MOD1

baseband
signal
SBB=SBB(t)

$\psi 1=\Phi-\Delta$

PDD

S PWM1 O

R

0

0

A

SPWM

$\psi 2=\Phi+\Delta$

S

MOD2

R PWM2 O

SPSPWM2

$S2=a*\sin(2\pi f_c t+\Phi(SBB(t))+\Delta(SBB(t)))$

Fig. 7

25

Fig. 8

power spectral density [dBm]

Fig. 9

Fig. 10

baseband
signal
SBB=SBB(t)

$S4=a*\sin(2\pi f_c t + \Phi(SBB(t)) + \Delta(SBB(t)))$

-2Δ

PDD → Φ+Δ → MOD → PWM

SPSPWM1

V
S VDEL

SPWM1

SPWM2

S FDEL

SPSPWM2

A

SPWM

0

**Fig. 11**

S1 → S PWM1 O
R

SPSPWM1 → SPA1 → SSPA1

0

0

S2 → R PWM2 O
S

SPSPWM2 → SPA2 → SSPA2

A

SSPA → RFILT → To Antenna

**Fig. 12**

28

Fig. 13

Fig. 14

Fig. 15

Fig. 16

Fig. 17

Fig. 18

**EP 2 670 101 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7724082 B2

### Non-patent literature cited in the description

- **HAWKSFORD et al.** Modulation and System Techniques in PWM and SDM Switching Amplifiers. *JAES, AES, 60 East 42nd Street,* 10165-2520